# EUROPEAN PATENT APPLICATION

(11) **EP 4 355 050 A1**
(43) Date of publication of application: **17.04.2024**
(21) Application number: 23202229.3
(22) Date of filing: 06.10.2023
(51) Int. Cl.: H10B 43/27, H10B 43/10, H10B 43/40, H10B 43/50

(54) **SEMICONDUCTOR MEMORY DEVICE, METHOD FOR FABRICATING THE SAME AND ELECTRONIC SYSTEM INCLUDING THE SAME**

(30) Priority: 11.10.2022 KR 20220129801; 14.04.2023 KR 20230049515
(71) Applicant: Samsung Electronics Co., Ltd., Suwon-si, Gyeonggi-do 16677 (KR)
(72) Inventor: CHOI, Chul Min, 16677 Suwon-si (KR); BYEON, Chang Hoon, 16677 Suwon-si (KR); SHIM, Sun Il, 16677 Suwon-si (KR)
(74) Representative: Marks & Clerk LLP

(57) **Abstract**

A semiconductor memory device may include a cell substrate; a mold structure including a plurality of gate electrodes stacked on the cell substrate; a channel structure penetrating the mold structure; a string select line on the mold structure; a string select channel structure penetrating the string select line and contacting the channel structure; an anti-arcing contact penetrating the mold structure; an insulating pattern between the anti-arcing contact and the plurality of gate electrodes; and an anti-arcing insulating pattern penetrating the string select line to be in contact with the anti-arcing contact.

## Description

### BACKGROUND

### 1. Technical Field

The present disclosure relates to a semiconductor memory device, a method for fabricating the same, and an electronic system including the same.

### 2. Description of the Related Art

In order to satisfy consumer demands for superior performance and inexpensive prices, increasing the integration density of semiconductor memory devices may be desired. In a semiconductor memory device, since the integration density of the semiconductor memory device may be an important factor in determining the price of a product, an increased integration density particularly may be required.

Meanwhile, in the case of a two-dimensional or planar semiconductor memory device, the integration density mainly may be determined by the area occupied by a unit memory cell, and thus the integration density may be greatly influenced by the level of fine pattern formation technology. However, since extremely high-priced equipment may be required for the miniaturization of patterns, the integration density of the two-dimensional semiconductor devices has been increased but is still limited. Accordingly, three-dimensional semiconductor devices having memory cells arranged three-dimensionally have been proposed.

### SUMMARY

Aspects of the present disclosure provide a semiconductor memory device with improved electrical characteristics and reliability.

Aspects of the present disclosure also provide a method for fabricating a semiconductor memory device with improved electrical characteristics and reliability.

Aspects of the present disclosure also provide an electronic system including a semiconductor memory device with improved electrical characteristics and reliability.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

According to an example embodiment of the present disclosure, a semiconductor memory device may include a cell substrate; a mold structure including a plurality of gate electrodes stacked on the cell substrate; a channel structure penetrating the mold structure; a string select line on the mold structure; a string select channel structure penetrating the string select line and contacting the channel structure; an anti-arcing contact penetrating the mold structure; an insulating pattern between the anti-arcing contact and the plurality of gate electrodes; and an anti-arcing insulating pattern penetrating the string select line and contacting the anti-arcing contact.

According to an example embodiment of the present disclosure, a semiconductor memory device may include a cell substrate including a cell array region and an extension region; a mold structure including a plurality of gate electrodes stacked on the cell array region, the plurality of gate electrodes being stacked in a stepwise manner on the extension region and each including a connection region having a top surface exposed; a channel structure penetrating the mold structure, the channel structure on the cell array region; a string select line on the mold structure; a string select channel structure penetrating the string select line and contacting the channel structure; an anti-arcing contact on the cell array region, the anti-arcing contact penetrating the mold structure, and a structure of the anti-arcing contact being different from a structure of the channel structure; and an insulating pattern between the anti-arcing contact and the plurality of gate electrodes.

According to an example embodiment of the present disclosure, an electronic system may include a main substrate; a semiconductor memory device on the main substrate; and a controller electrically connected to the semiconductor memory device. The semiconductor memory device may include a cell substrate, a mold structure, a channel structure, a string select line, a string select channel structure, an anti-arcing contact, an insulating pattern, an anti-arcing insulating pattern, and a plurality of cell contacts. The cell substrate may include a cell array region and an extension region. The mold structure may include a plurality of gate electrodes stacked on the cell array region. The plurality of gate electrodes may be stacked in a stepwise manner on the extension region and each may include a connection region having a top surface exposed such that the plurality of gate electrodes respectively may include connection regions. The channel structure may penetrate the mold structure on the cell array region. The string select line may be provided on the mold structure. The string select channel structure may penetrate the string select line and may contact the channel structure. The anti-arcing contact may penetrate the mold structure on the cell array region. The insulating pattern may be between the anti-arcing contact and the plurality of gate electrodes. The anti-arcing insulating pattern may penetrate the string select line and may contact the anti-arcing contact. The plurality of cell contacts may be electrically connected to the connection regions of the plurality of gate electrodes on the extension region.

According to an example embodiment of the present disclosure, a method for fabricating a semiconductor memory device may include forming a mold structure on a substrate, the mold structure including a plurality of gate electrodes stacked on the substrate; forming a channel structure penetrating the mold structure and an anti-arcing contact penetrating the mold structure, the anti-arcing contact being in contact with the substrate; forming a string select line on the mold structure; forming an anti-arcing sacrificial layer penetrating the string select line, the anti-arcing sacrificial layer contacting the anti-arcing contact and containing a conductive material; after the forming of the anti-arcing sacrificial layer, forming a string select channel structure on the channel structure, the string select channel structure penetrating the string select line; forming a hole through the string select line by removing the anti-arcing sacrificial layer, the hole exposing at least a part of the anti-arcing contact; and forming an anti-arcing insulating pattern in the hole, the anti-arcing insulating pattern filling the hole.

At least some of the above and other features of the invention are set out in the claims.

### BRIEF DESCRIPTION OF THE DRAWINGS

The above and other aspects and features of the present disclosure will become more apparent by describing in detail example embodiments thereof with reference to the attached drawings, in which:
FIG. 1 is an example block diagram explaining a semiconductor memory device according to some example embodiments;
FIG. 2 is an example circuit diagram explaining a semiconductor memory device according to some example embodiments;
FIG. 3 is an example layout diagram illustrating a semiconductor memory device according to some example embodiments;
FIG. 4 is a cross-sectional view taken along line I-I of FIG. 3;
FIG. 5 is an enlarged view of area Q1 of FIG. 4;
FIG. 6 is an enlarged view of area A of FIG. 4;
FIG. 7 is an enlarged view of area B of FIG. 4;
FIG. 8 is an enlarged view of area C of FIG. 4;
FIG. 9 is another example cross-sectional view for describing a semiconductor memory device according to some example embodiments;
FIG. 10 is another example cross-sectional view for describing a semiconductor memory device according to some example embodiments;
FIG. 11 is another example cross-sectional view for describing a semiconductor memory device according to some example embodiments;
FIG. 12 is an enlarged view of area Q2 of FIG. 11;
FIG. 13 is another example cross-sectional view for describing a semiconductor memory device according to some example embodiments;
FIG. 14 is an enlarged view of area Q3 of FIG. 13;
FIG. 15 is another example cross-sectional view for describing a semiconductor memory device according to some example embodiments;
FIG. 16 is an enlarged view of area Q4 of FIG. 15;
FIGS. 17 to 28 are views illustrating intermediate operations for explaining a method for fabricating a semiconductor memory device according to some example embodiments;
FIGS. 29 to 31 are views illustrating intermediate operations for explaining a method for fabricating a semiconductor memory device according to some example embodiments;
FIG. 32 is an example block diagram illustrating an electronic system according to some example embodiments;
FIG. 33 is an example perspective view illustrating an electronic system according to some example embodiments; and
FIG. 34 is a schematic cross-sectional view taken along line II-II' of FIG. 33.

### DETAILED DESCRIPTION

Expressions such as "at least one of," when preceding a list of elements, modify the entire list of elements and do not modify the individual elements of the list. For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC.

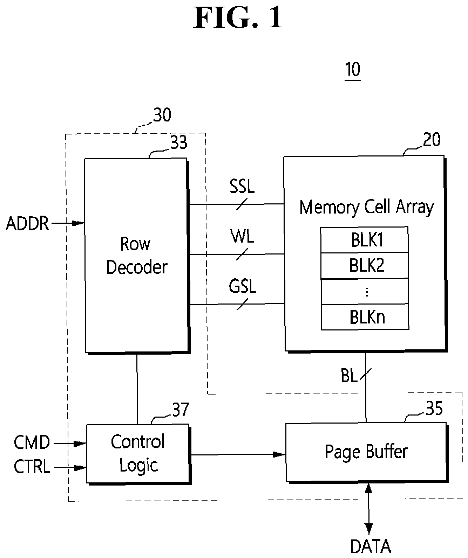

FIG. 1 is an example block diagram explaining a semiconductor memory device according to some example embodiments.

Referring to FIG. 1, a semiconductor memory device 10 according to some example embodiments includes a memory cell array 20 and a peripheral circuit 30.

The memory cell array 20 may include a plurality of memory cell blocks BLK1 to BLKn. Each of the memory cell blocks BLK1 to BLKn may include a plurality of memory cells. The memory cell array 20 may be connected to the peripheral circuit 30 through bit lines BL, word lines WL, at least one of string select lines SSL, and at least one of ground select lines GSL. The memory cell blocks BLK1 to BLKn may be connected to a row decoder 33 through the word lines WL, the string select lines SSL, and the ground select lines GSL. Further, the memory cell blocks BLK1 to BLKn may be connected to a page buffer 35 through the bit lines BL.

The peripheral circuit 30 may receive an address ADDR, a command CMD, and a control signal CTRL from outside of the semiconductor memory device 10, and may transmit and receive data DATA to and from an external device in communication with the semiconductor memory device 10. The peripheral circuit 30 may include a row decoder 33, a page buffer 35, and a control logic 37. The peripheral circuit 30 may further include various sub-circuits such as an input/output circuit, a voltage generation circuit for generating various voltages required for the operation of the semiconductor memory device 10, and an error correction circuit for correcting an error of data DATA read from the memory cell array 20.

The control logic 37 may be connected to the row decoder 33, the page buffer 35, the input/output circuit and the voltage generation circuit. The control logic 37 may control an overall operation of the semiconductor memory device 10. The control logic 37 may generate various internal control signals used in the semiconductor memory device 10 in response to the control signal CTRL. For example, the control logic 37 may adjust a voltage level provided to the word lines WL and the bit lines BL during the execution of a memory operation such as a program operation or an erase operation.

The row decoder 33 may select at least one of the plurality of memory cell blocks BLK1 to BLKn in response to the address ADDR. Further, the row decoder 33 may select at least one of the word lines WL, at least one of the string select lines SSL and at least one of the ground select lines GSL for the selected at least one of the memory cell blocks BLK1 to BLKn. Further, the row decoder 33 may transmit a voltage for performing a memory operation to the word lines WL of the selected at least one of the memory cell blocks BLK1 to BLKn.

The page buffer 35 may be connected to the memory cell array 20 through the bit lines BL. The page buffer 35 may operate as a write driver or a sense amplifier. Specifically, during the program operation, the page buffer 35 may operate as a write driver to apply, to the bit lines BL, a voltage corresponding to the data DATA intended to be stored in the memory cell array 20. On the other hand, during a read operation, the page buffer 35 may operate as a sense amplifier to sense the data DATA stored in the memory cell array 20.

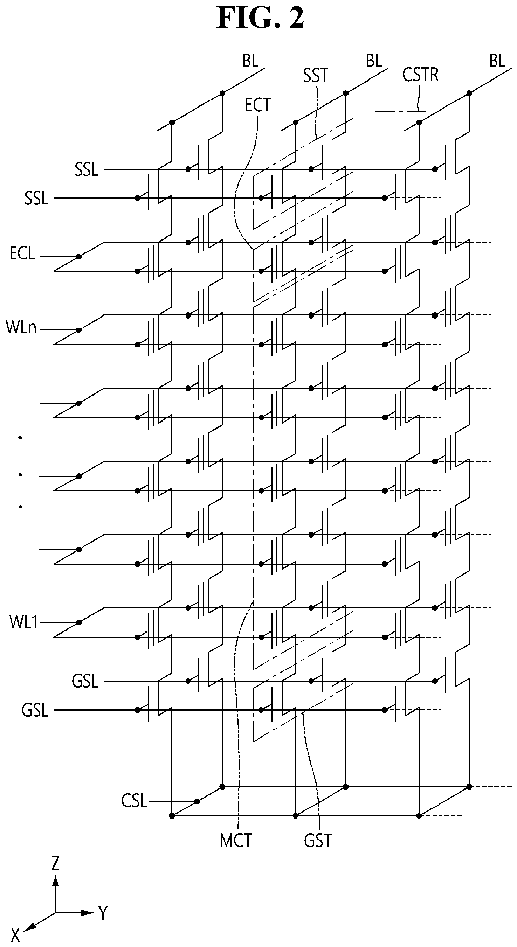

FIG. 2 is an example circuit diagram explaining a semiconductor memory device according to some example embodiments.

Referring to FIG. 2, a memory cell array (e.g., '20' in FIG. 1) of the semiconductor memory device according to some example embodiments may include a common source line CSL, a plurality of bit lines BL, and a plurality of cell strings CSTR.

The common source line CSL may extend in a first direction X. In some example embodiments, a plurality of common source lines CSL may be arranged two-dimensionally. For example, the plurality of common source lines CSL may extend in the first direction X while being spaced apart from each other. The same voltage may be applied to the common source lines CSL. Alternatively, different voltages may be applied to the common source lines CSL to be controlled separately.

The plurality of bit lines BL may be two-dimensionally arranged. For example, the bit lines BL may extend in the first direction X and be spaced apart from each other in the second direction Y. The plurality of cell strings CSTR may be connected in parallel to each of the bit lines BL. The cell strings CSTR may be commonly connected to the common source lines CSL. That is, the plurality of cell strings CSTR may be disposed between the bit lines BL and the common source lines CSL.

Each of the cell strings CSTR may include a ground select transistor GST connected to the common source line CSL, a string select transistor SST connected to the bit line BL, and a plurality of memory cell transistors MCT disposed between the ground select transistor GST and the string select transistor SST. Each of the memory cell transistors MCT may include a data storage element. The ground select transistor GST, the string select transistor SST, and the memory cell transistors MCT may be connected in series.

The common source line CSL may be commonly connected to the sources of the ground select transistors GST. Further, a ground select line GSL, a plurality of word lines WL1 to WLn, and a string select line SSL may be disposed between the common source line CSL and the bit line BL. The ground select line GSL may be used as a gate electrode of the ground select transistor GST. The word lines WL1 to WLn may be used as gate electrodes of the memory cell transistors MCT. The string select line SSL may be used as a gate electrode of the string select transistor SST.

In some example embodiments, an erase control transistor ECT may be disposed between the string select transistor SST and the memory cell transistors MCT. The common source line CSL may be commonly connected to sources of the erase control transistors ECT. Further, an erase control line ECL may be disposed between the string select line SSL and the word lines WL 1 to WLn. The erase control line ECL may be used as a gate electrode of the erase control transistor ECT. The erase control transistor ECT may perform an erase operation of the memory cell array by generating a gate induced drain leakage (GIDL).

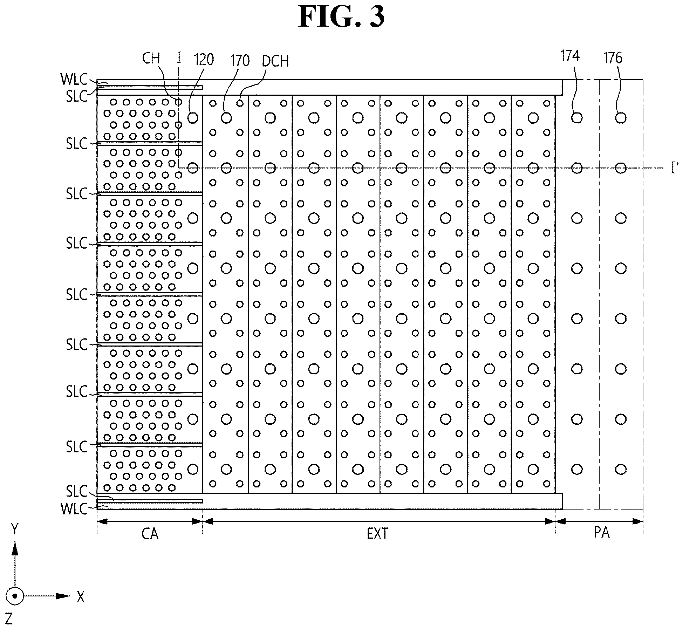

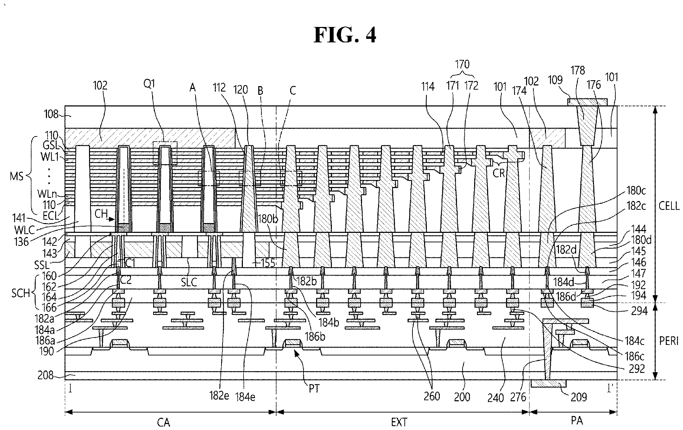

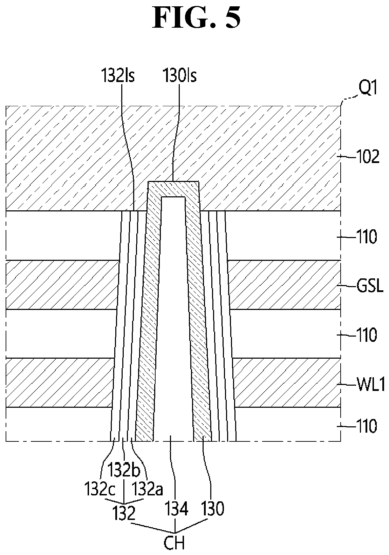

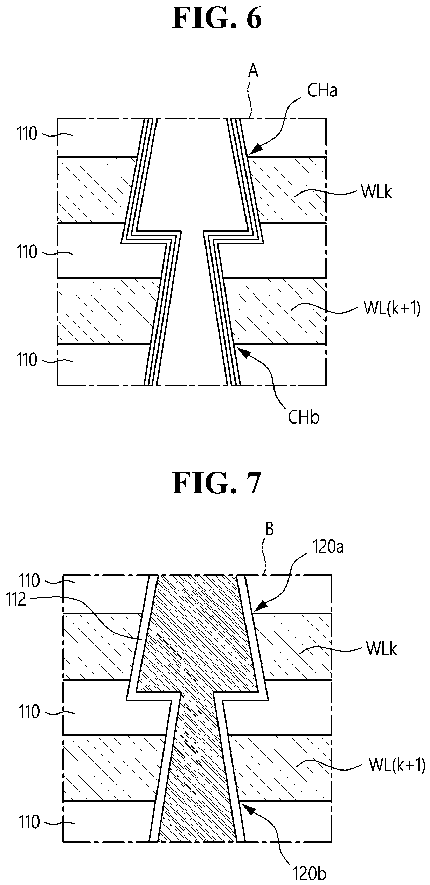

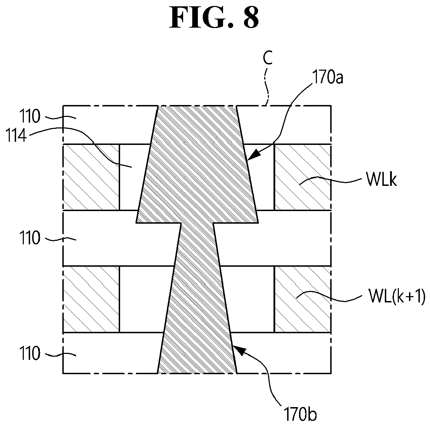

FIG. 3 is an example layout diagram illustrating a semiconductor memory device according to some example embodiments. FIG. 4 is a cross-sectional view taken along line I-I' of FIG. 3. FIG. 5 is an enlarged view of area Q1 of FIG. 4. FIG. 6 is an enlarged view of area A of FIG. 4. FIG. 7 is an enlarged view of area B of FIG. 4. FIG. 8 is an enlarged view of area C of FIG. 4.

Referring to FIGS. 3 and 4, a semiconductor memory device according to some example embodiments may include a memory cell structure CELL and a peripheral circuit structure PERI.

The memory cell structure CELL may include cell substrates 101 and 102, a mold structure MS, first to seventh interlayer insulating layers 141 to 147, a channel structure CH, a word line cutting structure WLC, the string select line SSL, a string isolation structure SLC, a string select channel structure SCH, an anti-arcing contact 120, an anti-arcing insulating pattern 155, a first insulating pattern 112, a second insulating pattern 114, a cell contact 170, a source contact 174, an input/output contact 176, first metal patterns 186a, 186b, 186c, and 186d, a first inter-wiring insulating layer 190, a first bonding via 192, and a first bonding metal 194.

The cell substrates 101 and 102 may include a cell array region CA, an extension region EXT, and a pad region PA.

A memory cell array (e.g., '20' in FIG. 1) including a plurality of memory cells may be disposed in the cell array region CA. For example, the channel structure CH, the first metal pattern 186a, the gate electrodes GSL, WL1 to WLn, and ECL, and the string select line SSL, which will be described later, may be disposed on the cell array region CA. In the following description, a surface of the cell substrate 101 and 102, on which the memory cell array is disposed, may be referred to as a front side of the cell substrate 101 and 102. On the contrary, a surface of the cell substrate 101 and 102 opposite to the front side of the cell substrate 101 and 102 may be referred to as a back side of the cell substrate 101 and 102.

The extension region EXT may be defined and disposed on a side of the cell array region CA. The extension region EXT may be disposed around the cell array region CA. The extension region EXT may surround the cell array region CA in plan view, for example. The gate electrodes GSL, WL1 to WLn, and ECL, which will be described later, may be stacked in a stepwise manner on the extension region EXT.

For example, the pad region PA may be defined and disposed on another side of the extension region EXT (for example, on a side opposite to the cell array region CA). The pad region PA may surround the extension region EXT in plan view, for example. The source contact 174 and the input/output contact 176, which will be described later, may be disposed on the pad region PA.

In some example embodiments, the cell substrates 101 and 102 may include an insulating layer 101 and a source layer 102. For example, the insulating layer 101 may be provided in the extension region EXT and the pad region PA, and the source layer 102 may be provided in the cell array region CA and the pad region PA. In some example embodiments, the source layer 102 may be formed on the cell array region CA, and may not be formed on the extension region EXT.

The source layer 102 may include, for example, a conductive material such as polysilicon or metal doped with impurities, but is not limited thereto. The source layer 102 may be provided as a common source line (e.g., 'CSL' in FIG. 2) of the semiconductor memory device. The source layer 102 may be referred to as a plate layer.

The bottom surface of the source layer 102 may be flat, for example. For another example, the source layer 102 may be formed along the bottom surface of the channel structure CH, and the source layer 102 may include an extension portion extending along the mold insulating layer 110 and a protrusion portion protruding from the extension portion toward the first insulating layer 108. The channel structure CH may overlap the protrusion portion in a third direction Z.

The insulating layer 101 may be formed around the source layer 102. The insulating layer 101 may include, for example, at least one of silicon oxide, silicon nitride, silicon oxynitride, or silicon carbide.

The mold structure MS may be disposed on the front sides of the cell substrates 101 and 102. The mold structure MS may include a plurality of gate electrodes GSL, WL1 to WLn, and ECL and a plurality of mold insulating layers 110 that are stacked on the cell substrates 101 and 102. Each of the gate electrodes GSL, WL1 to WLn, and ECL and each of the mold insulating layers 110 may have a layered structure extending in parallel to the front sides of the cell substrates 101 and 102. The gate electrodes GSL, WL1 to WLn, and ECL may be sequentially stacked on the cell substrates 101 and 102 while being spaced apart from each other by the mold insulating layers 110.

The gate electrodes GSL, WL1 to WLn, and ECL may be stacked in a stepwise manner on the extension region EXT. For example, the gate electrodes GSL, WL1 to WLn, and ECL may extend to different lengths in the first direction X and have a stepped portion. Accordingly, each of the gate electrodes GSL, WL1 to WLn, and ECL may include a connection region CR whose top surface is exposed on the extension region EXT. The connection region CR may be disposed at the end of each of the gate electrodes GSL, WL1 to WLn, and ECL. The gate electrodes GSL, WL1 to WLn, and ECL may extend to different lengths in the second direction Y and have a stepped portion.

For example, the thicknesses of the gate electrodes GSL, WL1 to WLn, and ECL in the connection region CR may be greater than the thicknesses of the gate electrodes GSL, WL1 to WLn, and ECL in a region other than the connection region CR. Hereinafter, the thickness may be measured with respect to the third direction Z. The third direction Z may intersect the first direction X and the second direction Y. The third direction Z may be a direction perpendicular to the front sides of the cell substrates 101 and 102. The first direction X and the second direction Y may be directions parallel to the front sides of the cell substrates 101 and 102. Hereinafter, the top surface, the bottom surface, the upper side, and the lower side are defined with respect to the third direction Z.

In some example embodiments, the gate electrodes GSL, WL1 to WLn, and ECL may include a ground select line GSL, word lines WL1 to WLn, and an erase control line ECL that are sequentially stacked on the cell substrates 101 and 102. The number and arrangement of the ground select line GSL, the word lines WL1 to WLn, and the erase control line ECL are merely illustrative, and are not limited to the illustrated one. In some embodiments, the erase control line ECL may be omitted. In some embodiments, a dummy word line may be further included.

Each of the gate electrodes GSL, WL1 to WLn, and ECL may include, a conductive material, for example, metal such as tungsten (W), cobalt (Co), and nickel (Ni), or a semiconductor material such as silicon, but is not limited thereto. For example, each of the gate electrodes GSL, WL1 to WLn, and ECL may include tungsten (W). The gate electrodes GSL, WL1 to WLn, and ECL may comprise, for example, multiple layers. For example, when the gate electrodes GSL, WL 1 to WLn, and ECL have multiple layers, the gate electrodes GSL, WL1 to WLn, and ECL may include a gate electrode barrier layer and a gate electrode filling layer.

The mold insulating layer 110 and the gate electrodes GSL, WL1 to WLn, and ECL may be alternately stacked. The mold insulating layer 110 may be stacked in a stepwise manner on the extension region EXT. For example, the mold insulating layer 110 may extend to different lengths in the first direction X and have a stepped portion. The mold insulating layer 110 may extend to different lengths in the second direction Y and have a stepped portion.

The mold insulating layer 110 may include an insulating material, for example, at least one of silicon oxide, silicon nitride, or silicon oxynitride, but is not limited thereto. For example, the mold insulating layer 110 may include silicon oxide.

The first interlayer insulating layer 141 may be disposed on the cell substrates 101 and 102 to cover the mold structure MS.

The channel structure CH may be disposed on the cell array region CA. Each of the plurality of channel structures CH may extend in the third direction Z and penetrate the mold structure MS. For example, the channel structure CH may be a pillar-shaped (for example, cylindrical) structure extending in the third direction Z. Accordingly, the channel structure CH may intersect each of the gate electrodes GSL, WL1 to WLn, and ECL. In some example embodiments, the width of the channel structure CH may decrease toward the cell substrates 101 and 102.

As shown in FIG. 5, the channel structure CH may include a first channel pattern 130 and a first channel insulating pattern 132.

The first channel pattern 130 may extend in the third direction Z to penetrate the mold structure MS. The first channel pattern 130 may have, for example, a cup shape. For another example, the first channel pattern 130 may have various shapes such as a cylindrical shape, a rectangular tube shape, and a solid pillar shape. The first channel insulating pattern 132 may be interposed between the first channel pattern 130 and each of the gate electrodes GSL, WL1 to WLn, and ECL. For example, the first channel insulating pattern 132 may extend along at least a part of an outer surface of the first channel pattern 130. In some example embodiments, the first channel insulating pattern 132 may be formed of multiple layers. For example, as shown in FIG. 5, the first channel insulating pattern 132 may include a tunnel insulating layer 132a, a charge storage layer 132b, and a blocking insulating layer 132c that are sequentially stacked on the outer surface of the first channel pattern 130.

The tunnel insulating layer 132a may include, for example, silicon oxide or a high-k material (e.g., aluminum oxide (Al₂O₃) or hafnium oxide (HfO₂)) having a higher dielectric constant than silicon oxide. The charge storage layer 132b may include, for example, silicon nitride. The blocking insulating layer 132c may include, for example, silicon oxide or a high-k material (e.g., aluminum oxide (Al₂O₃) or hafnium oxide (HfO₂)) having a higher dielectric constant than silicon oxide.

In some example embodiments, the channel structure CH may further include a first filling pattern 134. The first filling pattern 134 may fill an inside of the first channel pattern 130 having a cup shape. The first channel pattern 130 may cover an outer wall of the first filling pattern 134.

The source layer 102 may be electrically connected to the first channel pattern 130 of each channel structure CH. In some example embodiments, a part of the first channel pattern 130 may be disposed in the source layer 102. A bottom surface 130ls of the first channel pattern 130 may be disposed in the source layer 102. The first channel insulating pattern 132 may extend along a part of the side surface of the first channel pattern 130. The first channel insulating pattern 132 may expose the lower portion of the first channel pattern 130. The first channel insulating pattern 132 may expose the bottom surface 130ls of the first channel pattern 130 and a part of the side surface of the first channel pattern 130. The bottom surface 130ls of the first channel pattern 130 may be disposed lower than a bottom surface 1321s of the first channel insulating pattern 132. The bottom surface 130ls of the first channel pattern 130 may be in contact with the source layer 102. A part of the side surface of the first channel pattern 130 may be in contact with the source layer 102.

For example, the bottom surface 130ls of the first channel pattern 130 may be flat. Further, for example, the bottom surface 130ls of the first channel pattern 130 may have a stepped portion. For example, the bottom surface 1321s of the first channel insulating pattern 132 may be flat. Further, for example, the bottom surface 132ls of the first channel insulating pattern 132 may have a stepped portion. For example, the bottom surface of the tunnel insulating layer 132a may be disposed lower than the bottom surface of the charge storage layer 132b, and the bottom surface of the charge storage layer 132b may be disposed lower than the bottom surface of the blocking insulating layer 132c.

In some example embodiments, the channel structure CH may further include a first channel pad 136. The first channel pad 136 may be electrically connected to the first channel pattern 130.

In some example embodiments, the plurality of channel structures CH may be arranged in a zigzag or honeycomb shape. For example, as shown in FIG. 3, the plurality of channel structures CH may be arranged to be misaligned in the first direction X and/or the second direction Y parallel to the top surfaces of the cell substrates 101 and 102. The channel structure CH may further improve the integration density of the semiconductor memory device. The number and arrangement of the channel structures CH are merely illustrative, and are not limited to the illustrated one.

In some example embodiments, a dummy channel structure DCH may be disposed in the mold structure MS of the extension region EXT. The dummy channel structure DCH may have, for example, a shape similar to that of the channel structure CH.

Referring to FIG. 6, in some example embodiments, the channel structure CH may include a first channel CHa and a second channel CHb connected to each other. For example, the channel structure CH may be formed by a process for forming the first channel CHa and a process for forming the second channel CHb. The first channel CHa may be the lower portion of the channel structure CH, and the second channel CHb may be the upper portion of the channel structure CH. At the boundary between the first channel CHa and the second channel CHb, a width of the first channel CHa may be greater than that of the second channel CHb. The channel structure CH may have a bent portion at a boundary between the first channel CHa and the second channel CHb.

Further, a word line located near the boundary between the first channel CHa and the second channel CHb may be a dummy word line. For example, a word line WLk (k being a natural number smaller than n) and a word line WL(k+1) forming the boundary between the first channel CHa and the second channel CHb may be a dummy word line. In this case, data may not be stored in memory cells connected to the dummy word line. Alternatively, a number of pages corresponding to the memory cells connected to the dummy word line may be smaller than a number of pages corresponding to the memory cells connected to another word line. The voltage level applied to the dummy word line may be different from the voltage level applied to the other word lines.

Referring back to FIGS. 3 to 5, the word line cutting structure WLC may extend in the first direction X to cut the mold structure MS on the cell array region CA and the extension region EXT. Further, a plurality of word line cutting structures WLC may be spaced apart from each other and extend side by side in the first direction X. The mold structure MS may be divided by the word line cutting structure WLC to form a plurality of memory cell blocks (for example, 'BLK1 to BLKn' in FIG. 1). For example, two adjacent word line cutting structures WLC may define one memory cell block between them. The plurality of channel structures CH may be disposed in each of the memory cell blocks defined by the word line cutting structure WLC. In some example embodiments, the width of the word line cutting structure WLC may decrease toward the cell substrates 101 and 102.

The word line cutting structure WLC may extend in the first direction X to cut the source layer 102. The bottom surface of the word line cutting structure WLC may be lower than, for example, the top surface of the source layer 102. For another example, the bottom surface of the word line cutting structure WLC and the top surface of the source layer 102 may be disposed substantially on the same plane.

In some example embodiments, the word line cutting structure WLC may include an insulating material. For example, the word line cutting structure WLC may include at least one of silicon oxide, silicon nitride, or silicon oxynitride.

A second interlayer insulating layer 142 and a third interlayer insulating layer 143 may be disposed on the mold structure MS. The second interlayer insulating layer 142 may be disposed on the first interlayer insulating layer 141, and the third interlayer insulating layer 143 may be disposed on the second interlayer insulating layer 142.

The string select line SSL and a fourth interlayer insulating layer 144 may be disposed on the mold structure MS. The string select line SSL and the fourth interlayer insulating layer 144 may be disposed on the third interlayer insulating layer 143. The fourth interlayer insulating layer 144 may be disposed on the third interlayer insulating layer 143 on which the string select line SSL is not disposed. For example, the string select line SSL may be provided in the cell array region CA, and the fourth interlayer insulating layer 144 may be provided in the cell array region CA, the extension region EXT, and the pad region PA. The end of the string select line SSL may be provided, for example, in the cell array region CA. Further, for example, the end of the string select line SSL may be disposed in the extension region EXT between first studs 180b closest to the string select line SSL.

The string select line SSL and the gate electrodes GSL, WL1 to WLn, and ECL may be stacked in a stepwise manner. For example, the string select lines SSL may extend to different lengths in the first direction X and have a stepped portion. The string select lines SSL may extend to different lengths in the second direction Y and have a stepped portion.

For example, the thickness of the string select line SSL may be greater than the thickness of each of the gate electrodes GSL, WL1 to WLn, and ECL.

The string select line SSL may include a conductive material. The string select line SSL may include a semiconductor material such as polycrystalline silicon or monocrystalline silicon, and the semiconductor material may be an undoped material or a material containing p-type or n-type impurities. The string select line SSL may include, for example, polysilicon.

As shown in FIG. 3, the string isolation structure SLC may extend in the first direction X to isolate the string select line SSL on the cell array region CA. Further, the plurality of string isolation structures SLC may be spaced apart from each other and may extend side by side in the first direction X. The memory cell block defined by the word line cutting structure WLC may be divided by the string isolation structure SLC to form a plurality of string regions. For example, the string isolation structure SLC may define eight string regions in one memory cell block. At least a part of the string isolation structure SLC closest to the word line cutting structure WLC may overlap the word line cutting structure WLC in the third direction Z. Alternatively, the string isolation structure SLC closest to the word line cutting structure WLC may not overlap the word line cutting structure WLC in the third direction Z.

The string isolation structure SLC may penetrate the string select line SSL. The string isolation structure SLC may further penetrate, for example, the third interlayer insulating layer 143. In some example embodiments, the width of the string isolation structure SLC may decrease toward the cell substrates 101 and 102.

The string isolation structure SLC may include an insulating material such as at least one of silicon oxide, silicon nitride, or silicon oxynitride.

The string select channel structure SCH may be disposed on the cell array region CA. The string select channel structure SCH may extend in the third direction Z and penetrate the string select line SSL. The string select channel structure SCH may be disposed on the channel structure CH while penetrating the string select line SSL. A fifth interlayer insulating layer 145 may be disposed on the string select line SSL and the fourth interlayer insulating layer 144. The string select channel structure SCH may penetrate the fifth interlayer insulating layer 145, the string select line SSL, the third interlayer insulating layer 143, and the second interlayer insulating layer 142. In some example embodiments, the width of the string select channel structure SCH may decrease toward the cell substrates 101 and 102.

The string select channel structure SCH may include a second channel pattern 160, a second channel insulating pattern 162, a second filling pattern 164, and a second channel pad 166.

The second channel pattern 160 may extend in the third direction Z and penetrate the string select line SSL. The second channel pattern 160 may be in contact with the first channel pattern 130 and the first channel pad 136 of the channel structure CH. Accordingly, the string select channel structure SCH may be electrically connected to the channel structure CH.

In some example embodiments, the second channel pattern 160 in the second interlayer insulating layer 142 may have a shape protruding toward the second interlayer insulating layer 142. For example, the second channel pattern 160 may have a cup shape in which the width decreases toward the mold structure MS, and may have a width that increases in the second interlayer insulating layer 142.

Each of the first channel pattern 130 and the second channel pattern 160 may include a semiconductor material such as monocrystalline silicon, polycrystalline silicon, an organic semiconductor material, a carbon nanostructure, or the like.

The second channel insulating pattern 162 may be interposed between the second channel pattern 160 and the string select line SSL. For example, the second channel insulating pattern 162 may extend along an outer wall of the second channel pattern 160 in the third interlayer insulating layer 143, the string select line SSL, and the fifth interlayer insulating layer 145. Each of the first channel insulating pattern 132 and the second channel insulating pattern 162 may include at least one of, for example, silicon oxide, silicon nitride, silicon oxynitride, or a high-k material having a higher dielectric constant than that of silicon oxide. The high-k material may include, for example, at least one selected from the group consisting of aluminum oxide, hafnium oxide, lanthanum oxide, tantalum oxide, titanium oxide, lanthanum hafnium oxide, lanthanum aluminum oxide, dysprosium scandium oxide and a combination thereof. The second channel insulating pattern 162 may be interposed between the second channel pattern 160 and the string select line SSL.

The second filling pattern 164 may fill an inside of the second channel pattern 160. The second channel pattern 160 may cover the outer wall of the second filling pattern 164. Each of the first filling pattern 134 and the second filling pattern 164 may include an insulating material such as silicon oxide.

The second channel pad 166 may be electrically connected to the upper portion of the second channel pattern 160. Each of the first channel pad 136 and the second channel pad 166 may include, for example, polysilicon doped with impurities.

In some example embodiments, at least one string select channel structure SCH may be shifted in a direction away from the string isolation structure SLC that does not overlap the word line cutting structure WLC. For example, with respect to a center C1 of the channel structure CH, a center C2 of the string select channel structure SCH may be shifted in a direction away from the string isolation structure SLC that does not overlap the word line cutting structure WLC in the third direction Z. Accordingly, the area where the string isolation structure SLC is formed may be secured. For example, the shifted amount of the center C2 of the string select channel structure SCH with respect to the center C1 of the channel structure CH may be different for each string select channel structure SCH. For another example, among the string select channel structures SCH disposed between adjacent string isolation structures SLC, only the string select channel structure SCH closest to the string isolation structure SLC may be shifted in a direction away from the string isolation structure SLC.

The anti-arcing contact 120 may be disposed on the cell array region CA. The anti-arcing contact 120 may extend in the third direction Z and penetrate the mold structure MS. For example, the anti-arcing contact 120 may be a pillar-shaped (for example, cylindrical) structure extending in the third direction Z. In some example embodiments, the width of the anti-arcing contact 120 may decrease toward the cell substrates 101 and 102.

The anti-arcing contact 120 may cut a part of the cell substrates 101 and 102. The bottom surface of the anti-arcing contact 120 may be lower than the front sides of the cell substrates 101 and 102, for example. The bottom surface of the anti-arcing contact 120 may be disposed in the cell substrates 101 and 102. The bottom surface of the anti-arcing contact 120 may be in contact with the cell substrates 101 and 102.

For example, the anti-arcing contact 120 may overlap the source layer 102 in the third direction Z. The anti-arcing contact 120 may be in contact with the source layer 102. The anti-arcing contact 120 may be electrically connected to the source layer 102. For another example, the anti-arcing contact 120 may overlap the insulating layer 101 in the third direction Z. The bottom surface of the anti-arcing contact 120 may be disposed in the insulating layer 101. The anti-arcing contact 120 may be in contact with the insulating layer 101.

The anti-arcing contact 120 may have a structure different from that of the channel structure CH. The anti-arcing contact 120 may have a single layer structure. The anti-arcing contact 120 may include a conductive material, for example, metal such as tungsten (W), cobalt (Co), or nickel (Ni) or a semiconductor material such as silicon.

Referring to FIG. 7, in some example embodiments, the anti-arcing contact 120 may include a first anti-arcing contact 120a and a second anti-arcing contact 120b connected to each other. For example, the anti-arcing contact 120 may be formed by a process for the first anti-arcing contact 120a and a process for the second anti-arcing contact 120b. The first anti-arcing contact 120a may be the lower portion of the anti-arcing contact 120, and the second anti-arcing contact 120b may be the upper portion of the anti-arcing contact 120. At the boundary between the first anti-arcing contact 120a and the second anti-arcing contact 120b, a width of the first anti-arcing contact 120a may be greater than that of the second anti-arcing contact 120b. The anti-arcing contact 120 may have a bent portion at the boundary between the first anti-arcing contact 120a and the second anti-arcing contact 120b.

Referring back to FIGS. 3 to 5, the anti-arcing contact 120 may be disposed at the end of the string select line SSL. The anti-arcing contact 120 may be more adjacent to (i.e. closer to) the extension region EXT than the channel structure CH. For example, one anti-arcing contact 120 may be disposed between adjacent string isolation structures SLC.

The first insulating pattern 112 may be disposed between the anti-arcing contact 120 and the mold structure MS. In some example embodiments, the first insulating pattern 112 may extend along a side surface of the anti-arcing contact 120. Accordingly, the anti-arcing contact 120 may be electrically isolated from the gate electrodes GSL, WL1 to WLn, and ECL. The first insulating pattern 112 may expose the bottom surface of the anti-arcing contact 120.

The first insulating pattern 112 may include an insulating material such as at least one of silicon oxide, silicon nitride, or silicon oxynitride.

The anti-arcing insulating pattern 155 may be disposed on the cell array region CA. The anti-arcing insulating pattern 155 may extend in the third direction Z and penetrate the string select line SSL. The anti-arcing insulating pattern 155 may be in contact with the anti-arcing contact 120. Accordingly, the anti-arcing contact 120 may be electrically isolated from the first metal pattern 186a. In some example embodiments, the width of the anti-arcing insulating pattern 155 may decrease toward the cell substrates 101 and 102. The anti-arcing insulating pattern 155 may have a single layer structure. The anti-arcing insulating pattern 155 may include an insulating material such as at least one of silicon oxide, silicon nitride, or silicon oxynitride.

The cell contact 170 may be disposed on the extension region EXT. The cell contact 170 may extend in the third direction Z and penetrate the mold structure MS on the extension region EXT. The cell contact 170 may be electrically connected to each of the gate electrodes GSL, WL1 to WLn, and ECL through the connection region CR. For example, the cell contact 170 may penetrate the connection region CR, and the side surface of the cell contact 170 may be in contact with the inner surface of the connection region CR. For example, the bottom surface of the cell contact 170 may be disposed in the insulating layer 101.

In some example embodiments, the cell contact 170 may include a through portion 171 and a protrusion portion 172.

The through portion 171 may extend in the third direction Z and penetrate the mold structure MS on the extension region EXT. For example, the through portion 171 may be a pillar-shaped (for example, cylindrical) structure extending in the third direction Z. In some example embodiments, the width of the through portion 171 may decrease toward the cell substrates 101 and 102.

The protrusion portion 172 may protrude from the side surface of the through portion 171 to be in contact with the connection region CR. For example, the inner surface of the protrusion portion 172 may protrude from the side surface of the through portion 171. For example, the protrusion portion 172 may be an annular structure surrounding the side surface of the through portion 171. Accordingly, the cell contact 170 may be electrically connected to each of the gate electrodes GSL, WL1 to WLn, and ECL.

The second insulating pattern 114 may be disposed between the cell contact 170 and the mold structure MS. The second insulating pattern 114 may be disposed between the cell contact 170 and the gate electrodes GSL, WL1 to WLn, and ECL in a region other than the connection region CR. The second insulating pattern 114 may be disposed between the cell contact 170 and the gate electrodes GSL, WL1 to WLn, and ECL whose top surfaces are not exposed. For example, the second insulating pattern 114 may be an annular structure surrounding the side surface of the cell contact 170. Accordingly, the cell contact 170 may be electrically connected to the uppermost gate electrodes GSL, WL1 to WLn, and ECL, and may be electrically isolated from the other gate electrodes except the uppermost gate electrodes.

The second insulating pattern 114 may include an insulating material such as at least one of silicon oxide, silicon nitride, or silicon oxynitride.

In some example embodiments, the thickness of the connection region CR may be greater than those of other gate electrodes disposed thereunder. Accordingly, the thickness of the second insulating pattern 114 may be smaller than that of the protrusion portion 172.

Referring to FIG. 8, in some example embodiments, the cell contact 170 may include a first cell contact 170a and a second cell contact 170b connected to each other. For example, the cell contact 170 may be formed by a process for the first cell contact 170a and a process for the second cell contact 170b. The first cell contact 170a may be the lower portion of the cell contact 170, and the second cell contact 170b may be the upper portion of the cell contact 170. At a boundary between the first cell contact 170a and the second cell contact 170b, a width of the first cell contact 170a may be greater than that of the second cell contact 170b. The cell contact 170 may have a bent portion at the boundary between the first cell contact 170a and the second cell contact 170b.

Referring back to FIGS. 3 to 5, the source contact 174 and the input/output contact 176 may be disposed on the pad region PA. The source contact 174 and the input/output contact 176 may extend in the third direction Z and penetrate the first interlayer insulating layer 141 on the pad region PA. In some example embodiments, the width of the source contact 174 and the width of the input/output contact 176 may gradually decrease toward the cell substrates 101 and 102.

The mold structure MS may expose a part of the top surface of the source layer 102. The source contact 174 may be electrically connected to the source layer 102. For example, the bottom surface of the source contact 174 may be disposed in the source layer 102. The source contact 174 may be electrically connected to the source layer 102 while penetrating the top surface of the source layer 102 exposed by the mold structure MS. The mold structure MS may expose a part of the top surface of the insulating layer 101. The input/output contact 176 may be electrically connected to the first input/output pad 109. For example, the bottom surface of the input/output contact 176 may be disposed in the insulating layer 101. The input/output contact 176 may be electrically connected to the first input/output pad 109 while penetrating the top surface of the insulating layer 101 exposed by the mold structure MS.

The first insulating layer 108 may be disposed on the cell substrates 101 and 102. The first insulating layer 108 may cover the bottom surfaces of the cell substrates 101 and 102. The first input/output pad 109 may be disposed on the first insulating layer 108. The first input/output pad 109 may be electrically connected to the peripheral circuit structure PERI through the input/output contact 176.

In some example embodiments, a contact 178 may penetrate the first insulating layer 108 and at least a part of the insulating layer 101. The first input/output pad 109 may be electrically connected to the input/output contact 176 through the contact 178. In some example embodiments, the width of the contact 178 may decrease toward the first interlayer insulating layer 141.

Each of the cell contact 170, the source contact 174, the input/output contact 176, and the contact 178 may include a conductive material, for example, a metal such as tungsten (W), cobalt (Co), or nickel (Ni) or a semiconductor material such as silicon. The first input/output pad 109 may include a conductive material. For example, the first input/output pad 109 may include aluminum (Al).

In some example embodiments, each of the source contact 174 and the input/output contact 176 may include a first portion and a second portion connected to each other. For example, the source contact 174 and the input/output contact 176 may be formed by a process for the first portion and a process for the second portion, respectively. The first portion may be the lower portions of the source contact 174 and the input/output contact 176, and the second portion may be the upper portions of the source contact 174 and the input/output contact 176. At a boundary between the first portion and the second portion, a width of the first portion may be greater than the width of the second portion. Each of the source contact 174 and the input/output contact 176 may include a bent portion.

The first metal patterns 186a, 186b, 186c, and 186d may be disposed on the string select line SSL and the fourth interlayer insulating layer 144. The string select channel structure SCH, the cell contact 170, the source contact 174, the input/output contact 176, and the string select line SSL may be electrically connected to the first metal patterns 186a, 186b, 186c and 186d.

For example, studs 182a and 184a may be sequentially disposed on the string select channel structure SCH. The string select channel structure SCH may be electrically connected to the first metal pattern 186a through the studs 182a and 184a. The first metal pattern 186a may be a bit line (for example, 'BL' in FIG. 2) of the semiconductor memory device. Studs 180b, 182b, and 184b may be sequentially disposed on the cell contact 170. The cell contact 170 may be electrically connected to the first metal pattern 186b through the studs 180b, 182b, and 184b. Studs 180c, 182c, and 184c may be sequentially disposed on the source contact 174. The source contact 174 may be electrically connected to the first metal pattern 186c through the studs 180c, 182c, and 184c. Studs 180d, 182d, and 184d may be sequentially disposed on the input/output contact 176. The input/output contact 176 may be electrically connected to the first metal pattern 186d through the studs 180d, 182d, and 184d. Studs 182e and 184e may be sequentially disposed on the string select line SSL. The string select line SSL may be electrically connected to the first metal pattern 186a through the studs 182e and 184e.

Studs 180b, 180c, and 180d may be disposed in the second to the fifth interlayer insulating layers 142 to 145. Sixth and seventh interlayer insulating layers 146 and 147 may be sequentially stacked on the fifth interlayer insulating layer 145. The first inter-wiring insulating layer 190 may be disposed on the seventh inter-layer insulating layer 147. The studs 182a, 182b, 182c, and 182d may be disposed in the sixth interlayer insulating layer 146. The stud 182e may be disposed in the fifth and sixth interlayer insulating layers 145 and 146. The studs 184a, 184b, 184c, 184d and 184e may be disposed in the seventh interlayer insulating layer 147. The first metal patterns 186a, 186b, 186c, and 186d may be disposed in the first inter-wiring insulating layer 190.

Each of the first to seventh interlayer insulating layers 141 to 147 may include at least one of, for example, silicon oxide, silicon nitride, silicon oxynitride or a low-k material having a lower dielectric constant than that of silicon oxide. For example, the third interlayer insulating layer 143 may include a nitride-based insulating material, and the first and second interlayer insulating layers 141 and 142 and the fourth to seventh interlayer insulating layers 144 to 147 may include an oxide-based insulating material.

For example, the stud connected to the first metal pattern 186a may not be disposed on the anti-arcing insulating pattern 155. At least one of the first stud or the second stud may not be disposed on the anti-arcing insulating pattern 155. For another example, the stud connected to the first metal pattern 186a may be disposed on the anti-arcing insulating pattern 155. However, the anti-arcing contact 120 and the first metal pattern 186a may be electrically isolated by the anti-arcing insulating pattern 155.

The peripheral circuit structure PERI may include a peripheral circuit board 200, a peripheral circuit element PT, a wiring structure 260, a second inter-wiring insulating layer 240, a second bonding via 292, and a second bonding metal 294.

The peripheral circuit board 200 may include, for example, a semiconductor substrate such as a silicon substrate, a germanium substrate, or a silicon-germanium substrate. Alternatively, the peripheral circuit board 200 may include a silicon-on-insulator (SOI) substrate or a germanium-on-insulator (GOI) substrate.

The peripheral circuit element PT may be formed on the peripheral circuit board 200. The peripheral circuit element PT may constitute a peripheral circuit (e.g., '30' in FIG. 1) that controls the operation of the semiconductor memory device. For example, the peripheral circuit element PT may include a control logic (e.g., '37' in FIG. 1), a row decoder (e.g., '33' in FIG. 1), and a page buffer (e.g., '35' in FIG. 1). In the following description, a surface of the peripheral circuit board 200, on which the peripheral circuit element PT is disposed, may be referred to as a front surface of the peripheral circuit board 200. On the contrary, a surface of the peripheral circuit board 200, which is opposite to the front surface of the peripheral circuit board 200, may be referred to as a rear surface of the peripheral circuit board 200.

The peripheral circuit element PT may include, for example, a transistor, but is not limited thereto. For example, the peripheral circuit element PT may include various active elements such as a transistor, as well as various passive elements such as a capacitor, a resistor, and an inductor.

The wiring structure 260 may be formed on the peripheral circuit element PT. For example, the second inter-wiring insulating layer 240 may be formed on the front side of the peripheral circuit board 200, and the wiring structure 260 may be formed in the second inter-wiring insulating layer 240. The wiring structure 260 may be electrically connected to the peripheral circuit element PT. The number and arrangement of layers of the illustrated inter-wiring structure 260 are merely illustrative, and are not limited thereto.

The peripheral circuit structure PERI may be disposed on the memory cell structure CELL. In some example embodiments, the front side of the peripheral circuit board 200 may face the front sides of the cell substrates 101 and 102. The peripheral circuit structure PERI may be disposed on the front sides of the cell substrates 101 and 102. The mold structure MS may be disposed between the cell substrates 101 and 102 and the peripheral circuit structure PERI.

The semiconductor memory device according to some example embodiments may have a chip to chip (C2C) structure. The C2C structure may be formed by manufacturing a first chip including the memory cell structure CELL on a first wafer (e.g., the cell substrates 101 and 102), manufacturing a second chip including the peripheral circuit structure PERI on a second wafer (e.g., the peripheral circuit board 200) different from the first wafer, and then connecting the first chip to the second chip by a bonding method.

For example, the bonding method may refer to a method of electrically connecting the first bonding metal 194 formed at an uppermost metal layer of the first chip and the second bonding metal 294 formed at an uppermost metal layer of the second chip, to each other. For example, when the first bonding metal 194 and the second bonding metal 294 are formed of copper (Cu), the bonding method may be a Cu-Cu bonding method. However, this is only an example, and the first bonding metal 194 and the second bonding metal 294 may be formed of various other metals such as aluminum (Al) or tungsten (W).

Since the first bonding metal 194 and the second bonding metal 294 are bonded, the first metal patterns 186a, 186b, 186c, and 186d may be connected to the wiring structure 260. The first metal patterns 186a, 186b, 186c, and 186d may be electrically connected to the first bonding metal 194 through the first bonding via 192. The first bonding via 192 and the first bonding metal 194 may be disposed in the first inter-wiring insulating layer 190. The wiring structure 260 may be electrically connected to the second bonding metal 294 through the second bonding via 292. The second bonding via 292 and the second bonding metal 294 may be disposed in the second inter-wiring insulating layer 240. Accordingly, the first metal pattern 186a, each of the gate electrodes GSL, WL1 to WLn, and ECL, or the string select line SSL may be electrically connected to at least one of the peripheral circuit elements PT.

The second insulating layer 208 may be disposed on the peripheral circuit board 200. The second insulating layer 208 may cover the bottom surface of the peripheral circuit board 200. The second input/output pad 209 may be disposed on the second insulating layer 208. The second input/output pad 209 may be electrically connected to at least one of the peripheral circuit elements PT disposed in the peripheral circuit structure PERI through the second input/output contact 276. The second input/output pad 209 may be electrically isolated from the peripheral circuit board 200 by the second insulating layer 208.

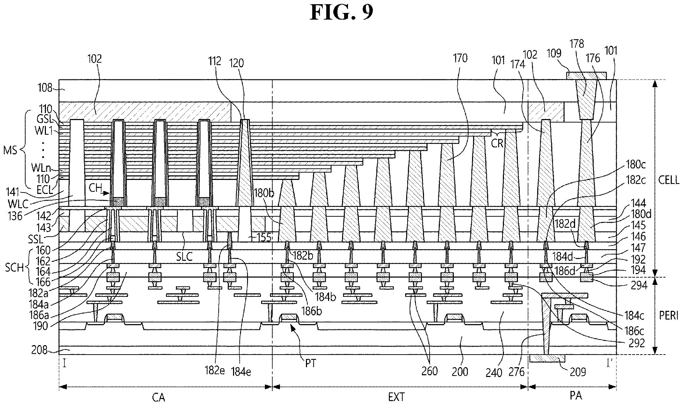

FIG. 9 is another example cross-sectional view for describing a semiconductor memory device according to some example embodiments. For reference, FIG. 9 is another cross-sectional view taken along line I-I' of FIG. 3. For simplicity of description, redundant parts of the description made with reference to FIGS. 1 to 8 may be recapitulated or omitted.

Referring to FIG. 9, in the semiconductor memory device according to some example embodiments, the cell contact 170 may extend in the third direction Z and penetrate the first interlayer insulating layer 141 on the extension region EXT. The bottom surface of the cell contact 170 may be in contact with the connection region CR of each of the gate electrodes GSL, WL1 to WLn, and ECL. Accordingly, the cell contact 170 may be electrically connected to the uppermost gate electrodes GSL, WL1 to WLn, and ECL, and may be electrically isolated from the other gate electrodes except the uppermost gate electrodes. The second insulating pattern ('114' in FIG. 4) may be omitted. For example, the bottom surface of the cell contact 170 may be disposed in each of the gate electrodes GSL, WL1 to WLn, and ECL.

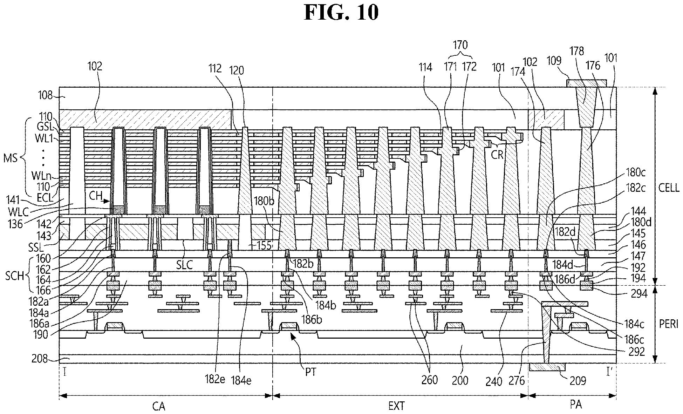

FIG. 10 is another example cross-sectional view for describing a semiconductor memory device according to some example embodiments. For reference, FIG. 10 is another cross-sectional view taken along line I-I' of FIG. 3. For simplicity of description, redundant parts of the description made with reference to FIGS. 1 to 8 may be recapitulated or omitted.

Referring to FIG. 10, in the semiconductor memory device according to some example embodiments, the first insulating pattern 112 may be disposed between the anti-arcing contact 120 and the gate electrodes GSL, WL1 to WLn, and ECL. For example, the first insulating pattern 112 may be an annular structure surrounding the side surface of the anti-arcing contact 120. Accordingly, the anti-arcing contact 120 may be electrically isolated from the gate electrodes GSL, WL1 to WLn, and ECL.

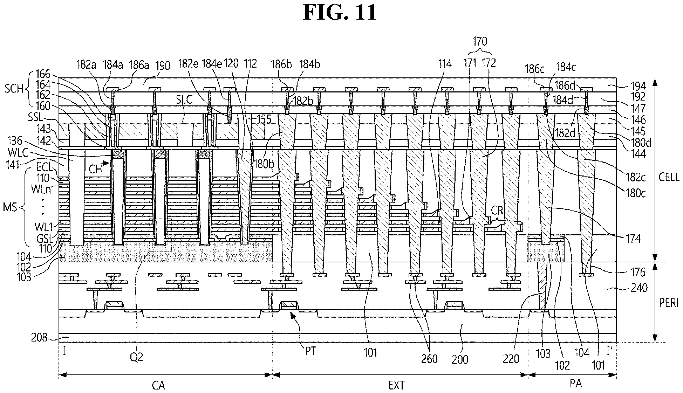

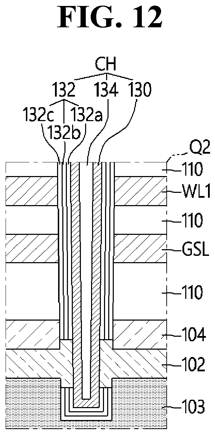

FIG. 11 is another example cross-sectional view for describing a semiconductor memory device according to some example embodiments. FIG. 12 is an enlarged view of area Q2 of FIG. 11. For reference, FIG. 11 is another cross-sectional view taken along line I-I' of FIG. 3. For simplicity of description, redundant parts of the description made with reference to FIGS. 1 to 8 may be recapitulated or omitted.

Referring to FIGS. 11 and 12, in the semiconductor memory device according to some example embodiments, the cell substrates 101, 102, 103, and 104 may include the insulating layer 101, the source layer 102, a semiconductor layer 103, and a support layer 104. For example, the insulating layer 101 may be provided in the extension region EXT and the pad region PA, and the source layer 102, the semiconductor layer 103, and the support layer 104 may be provided in the cell array region CA and the pad region PA. In some example embodiments, the source layer 102, the semiconductor layer 103, and the support layer 104 may be formed on the cell array region CA, and may not be formed on the extension region EXT.

The semiconductor layer 103 may include, for example, a semiconductor substrate such as a silicon substrate, a germanium substrate, or a silicon-germanium substrate. Alternatively, the semiconductor layer 103 may include a silicon-on-insulator (SOI) substrate or a germanium-on-insulator (GOI) substrate. The semiconductor layer 103 may include, for example, polysilicon doped with impurities, metal, or metal silicide. The semiconductor layer 103 may be formed of multiple layers.

The source layer 102 may be interposed between the semiconductor layer 103 and the mold structure MS. The source layer 102 may conformally extend along the top surface of the semiconductor layer 103. The source layer 102 may be electrically connected to the first channel pattern 130 of each channel structure CH. For example, as shown in FIG. 12, the channel structure CH may penetrate the source layer 102. The lower portion of the channel structure CH may be disposed in the semiconductor layer 103. The source layer 102 may be in contact with the side surface of the first channel pattern 130 while penetrating the first channel insulating pattern 132.

In some example embodiments, a part of the source layer 102 adjacent to the first channel pattern 130 may have a shape protruding toward the first channel insulating pattern 132. For example, in a region adj acent to the first channel pattern 130, the length of the source layer 102 extending in the third direction Z may further increase. Accordingly, the source layer 102 may be in contact with the first channel pattern 130 over a larger area.

In some example embodiments, a base insulating layer may be interposed between the semiconductor layer 103 and the source layer 102. The base insulating layer may include, for example, at least one of silicon oxide, silicon nitride, or silicon oxynitride, but is not limited thereto.

The support layer 104 may be formed on the semiconductor layer 103 and the source layer 102. The support layer 104 may be interposed between the source layer 102 and the mold structure MS. For example, the support layer 104 may conformally extend along the top surface of the semiconductor layer 103 and the top surface of the source layer 102. The support layer 104 may include, for example, polysilicon.

The support layer 104 may be used as a support to prevent a mold stack from falling or collapsing in a replacement operation for forming the source layer 102. For example, the source layer 102 may expose a part of the top surface of the semiconductor layer 103, and a part of the support layer 104 may extend along the exposed top surface of the semiconductor layer 103 to be in contact with the top surface of the semiconductor layer 103.

For example, the top surface of the support layer 104 and the top surface of the insulating layer 101 may be disposed substantially on the same plane. For another example, the top surface of the support layer 104 may be disposed lower than the top surface of the insulating layer 101.

The semiconductor layer 103, the source layer 102, and the support layer 104 may be provided as a common source line (for example, 'CSL' in FIG. 2) of the semiconductor memory device.

For example, the anti-arcing contact 120 may overlap the source layer 102 in the third direction Z. The anti-arcing contact 120 may cut parts of the source layer 102, the support layer 104, and the semiconductor layer 103. The bottom surface of the anti-arcing contact 120 may be disposed in the semiconductor layer 103. The anti-arcing contact 120 may be in contact with the semiconductor layer 103. For another example, the anti-arcing contact 120 may overlap the insulating layer 101 in the third direction Z. The bottom surface of the anti-arcing contact 120 may be disposed in the insulating layer 101. The anti-arcing contact 120 may be in contact with the insulating layer 101.

The word line cutting structure WLC may cut the source layer 102 and the support layer 104. For example, the bottom surface of the word line cutting structure WLC may be disposed lower than the bottom surface of the source layer 102. For another example, the bottom surface of the word line cutting structure WLC and the bottom surface of the source layer 102 may be disposed substantially on the same plane.

In the semiconductor memory device according to some example embodiments, the front side of the peripheral circuit board 200 may face the back sides of the cell substrates 101, 102, 103, and 104. The peripheral circuit structure PERI may be disposed on the rear surfaces of the cell substrates 101, 102, 103, and 104. The cell substrates 101, 102, 103, and 104 may be disposed between the mold structure MS and the peripheral circuit structure PERI.

For example, the cell contact 170 or the input/output contact 176 may be electrically connected to the wiring structure 260 while penetrating the insulating layer 101. For another example, the cell contact 170 or the input/output contact 176 may be electrically connected to the wiring structure 260 through a separate contact.

The peripheral circuit structure PERI may further include a through via 220. The through via 220 may connect the semiconductor layer 103 and the peripheral circuit board 200.

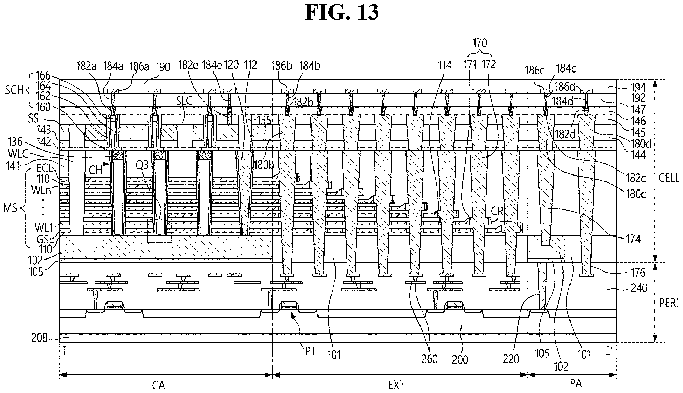

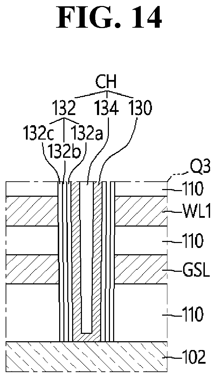

FIG. 13 is another example cross-sectional view for describing a semiconductor memory device according to some example embodiments. FIG. 14 is an enlarged view of area Q3 of FIG. 13. For reference, FIG. 13 is another cross-sectional view taken along line I-I' of FIG. 3. For simplicity of description, redundant parts of the description made with reference to FIGS. 11 to 12 may be recapitulated or omitted.

Referring to FIGS. 13 and 14, in the semiconductor memory device according to some example embodiments, the bottom surface of the first channel pattern 130 of the channel structure CH may be in contact with the source layer 102. The source layer 102 may be in further contact with the bottom surface of the first channel insulating pattern 132, for example. The channel structure CH may not penetrate the source layer 102.

In some example embodiments, the cell substrates 101, and 102 may further include a metal silicide layer 105 disposed between the source layer 102 and the peripheral circuit structure PERI.

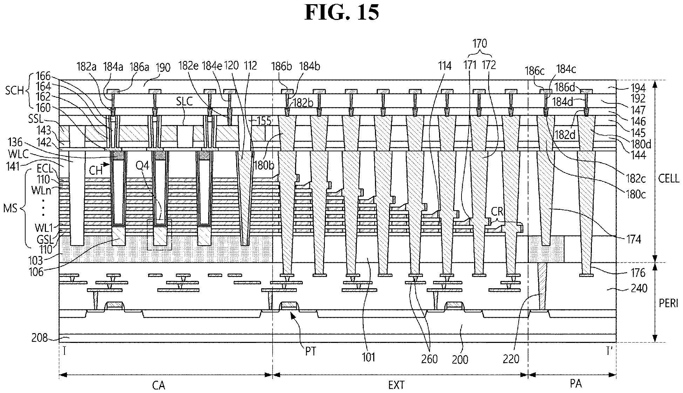

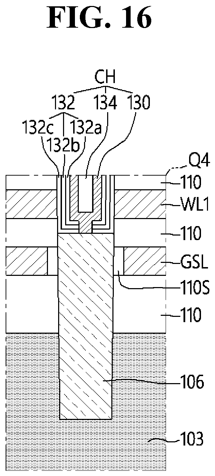

FIG. 15 is another example cross-sectional view for describing a semiconductor memory device according to some example embodiments. FIG. 16 is an enlarged view of area Q4 of FIG. 15. For reference, FIG. 15 is another cross-sectional view taken along line I-I' of FIG. 3. For simplicity of description, redundant parts of the description made with reference to FIGS. 11 to 12 may be recapitulated or omitted.

Referring to FIGS. 15 and 16, the semiconductor memory device according to some example embodiments may include a source pattern 106. The source pattern 106 may be disposed on the semiconductor layer 103. The source pattern 106 may be electrically connected to the first channel pattern 130 of the channel structure CH. For example, the first channel pattern 130 may be in contact with the top surface of the source pattern 106 while penetrating the first channel insulating pattern 132. The source pattern 106 and the semiconductor layer 103 may be provided as a common source line (e.g., 'CSL' in FIG. 2) of the semiconductor memory device.

The source pattern 106 may include, for example, a conductive material such as polysilicon or metal doped with impurities, but is not limited thereto. The source pattern 106 may be formed, for example, from the semiconductor layer 103 through a selective epitaxial growth step, but is not limited thereto.

For example, the lower portion of the source pattern 106 may be buried in the semiconductor layer 103. For another example, the bottom surface of the source pattern 106 and the top surface of the semiconductor layer 103 may be disposed substantially on the same plane.

In some example embodiments, the top surface of the source pattern 106 may intersect some of the gate electrodes GSL, WL1 to WLn, and ECL. For example, the top surface of the source pattern 106 may be formed higher than the top surface of the ground select line GSL. In this case, a gate insulating layer 110S may be interposed between the source pattern 106 and the gate electrode (for example, the ground select line GSL) intersecting the source pattern 106.

The anti-arcing contact 120 may be in contact with the source layer 102. For example, the bottom surface of the anti-arcing contact 120 may be disposed in the source layer 102, and may be in contact with the source layer 102. For another example, the bottom surface of the anti-arcing contact 120 may be disposed in the semiconductor layer 103, and the side surface of the anti-arcing contact 120 may be in contact with the source layer 102.

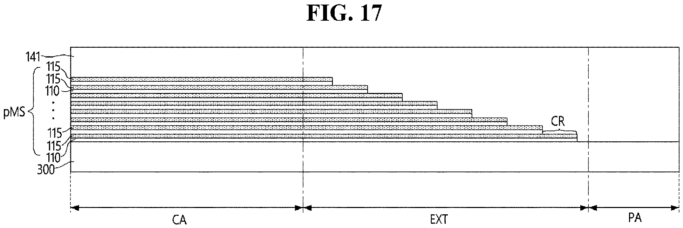

FIGS. 17 to 28 are views illustrating intermediate operations for explaining a method for fabricating a semiconductor memory device according to some example embodiments. For simplicity of description, redundant parts of the description made with reference to FIGS. 1 to 8 may be recapitulated or omitted.

Referring to FIG. 17, a substrate 300 including the cell array region CA, the extension region EXT, and the pad region PA may be provided.

A pre-mold structure pMS may be formed on the front side of the substrate 300. The pre-mold structure pMS may include a plurality of mold insulating layers 110 and a plurality of mold sacrificial layers 115 that are alternately stacked on the substrate 300. The pre-mold structure pMS on the extension region EXT may be patterned in a stepwise manner. Accordingly, each mold sacrificial layer 115 on the extension region EXT may include the connection region CR whose top surface is exposed on the extension region EXT. In the following description, the surface of the substrate 300 on which the pre-mold structure pMS is formed may be referred to as the front side of the substrate 300. On the contrary, the surface of the substrate 300 opposite to the front side of the substrate 300 may be referred to as the back side of the substrate 300.

The mold sacrificial layer 115 may include a material having an etch selectivity with respect to the mold insulating layer 110. For example, the mold insulating layer 110 may include silicon oxide, and the mold sacrificial layer 115 may include silicon nitride.

The first interlayer insulating layer 141 covering the substrate 300 and the pre-mold structure pMS may be formed.

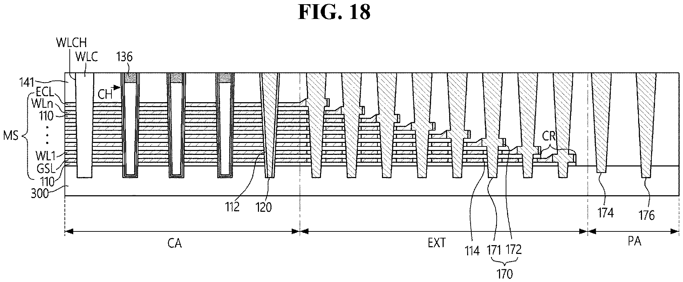

Referring to FIGS. 17 and 18, the channel structure CH penetrating the pre-mold structure pMS may be formed on the cell array region CA. After a channel hole penetrating the pre-mold structure pMS is formed, the channel structure CH filling the channel hole may be formed. The bottom surface of the channel structure CH may be disposed in the substrate 300. The channel structure CH may include the first channel pad 136 formed at an upper portion.

The anti-arcing contact 120 penetrating the pre-mold structure pMS may be formed on the cell array region CA. After an anti-arcing hole penetrating the pre-mold structure pMS is formed, the anti-arcing contact 120 filling the anti-arcing hole may be formed. For example, the channel hole and the anti-arcing hole may be formed at the same time. The first insulating pattern 112 may be formed on the sidewall of the anti-arcing contact 120. A part of the anti-arcing contact 120 may be disposed in the substrate 300. The bottom surface of the anti-arcing contact 120 may be disposed in the substrate 300.

The cell contact 170 penetrating the pre-mold structure pMS may be formed on the extension region EXT. The cell contact 170 may include the through portion 171 extending in the third direction Z and the protrusion portion 172 protruding from the through portion 171 toward the mold sacrificial layer 115 in the connection region CR. The second insulating pattern 114 may be formed between the through portion 171 and the mold sacrificial layer 115 disposed under the protrusion portion 172. The second insulating pattern 114 may be formed between the mold sacrificial layer 115 and the cell contact 170 in a region other than the connection region CR. A part of the cell contact 170 may be disposed in the substrate 300. The bottom surface of the cell contact 170 may be disposed in the substrate 300.

The source contact 174 penetrating the first interlayer insulating layer 141 may be formed on the substrate 300 of the pad region PA. The input/output contact 176 penetrating the first interlayer insulating layer 141 may be formed on the substrate 300 of the pad region PA. A part of the input/output contact 176 may be disposed in the substrate 300. The bottom surface of the input/output contact 176 may be disposed in the substrate 300.

A word line cutting hole WLCH penetrating the pre-mold structure pMS may be formed on the cell array region CA. The word line cutting hole WLCH may penetrate the front side of the substrate 300. The bottom surface of the word line cutting hole WLCH may be disposed in the substrate 300.

The gate electrodes GSL, WL1 to WLn, and ECL may be formed. The gate electrodes GSL, WL1 to WLn, and ECL may be formed by a replacement process. The mold sacrificial layer 115 exposed by the word line cutting structure WLC may be selectively removed. Next, the gate electrodes GSL, WL1 to WLn, and ECL replacing the region where the mold sacrificial layer 115 is removed may be formed. Accordingly, the mold structure MS including the plurality of gate electrodes GSL, WL1 to WLn, and ECL may be formed. After the mold structure MS is formed, the word line cutting structure WLC filling the word line cutting hole WLCH may be formed.

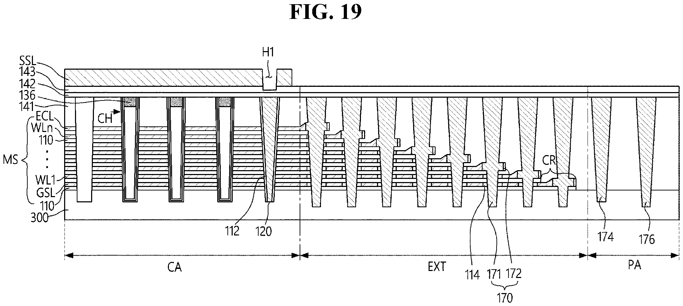

Referring to FIG. 19, the second interlayer insulating layer 142, the third interlayer insulating layer 143, and the string select line SSL may be sequentially formed on the first interlayer insulating layer 141.

A first hole H1 penetrating the string select line SSL may be formed. The first hole H1 may overlap the anti-arcing contact 120 in a direction perpendicular to the front side of the substrate 300. The third interlayer insulating layer 143 may include a material having an etch selectivity with respect to the second interlayer insulating layer 142. For example, the second interlayer insulating layer 142 may include silicon oxide, and the third interlayer insulating layer 143 may include silicon nitride. The first hole H1 may expose the third interlayer insulating layer 143. For example, the bottom surface of the first hole H1 may be disposed in the third interlayer insulating layer 143. The first hole H1 may expose the third interlayer insulating layer 143.

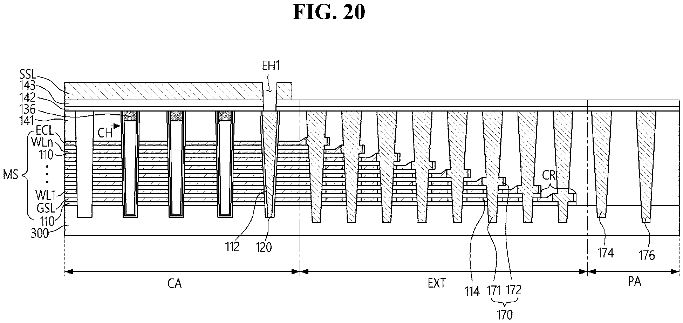

Referring to FIG. 20, a first extension hole EH1 may be formed by removing the third interlayer insulating layer 143 and the second interlayer insulating layer 142 through the first hole H1. The first extension hole EH1 may expose at least a part of the top surface of the anti-arcing contact 120.

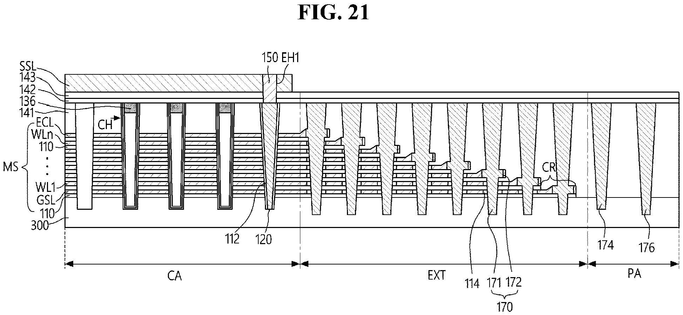

Referring to FIG. 21, an anti-arcing sacrificial layer 150 filling the first extension hole EH1 may be formed. The anti-arcing sacrificial layer 150 may be in contact with the anti-arcing contact 120 and the string select line SSL. The anti-arcing contact 120 may be electrically connected to the string select line SSL through the anti-arcing sacrificial layer 150. The string select line SSL may be connected to the substrate 300 through the anti-arcing sacrificial layer 150 and the anti-arcing contact 120.

The anti-arcing sacrificial layer 150 may include a conductive material. The anti-arcing sacrificial layer 150 may include at least one of polysilicon, tungsten (W), carbon (C), titanium nitride (TiN), or a combination thereof.

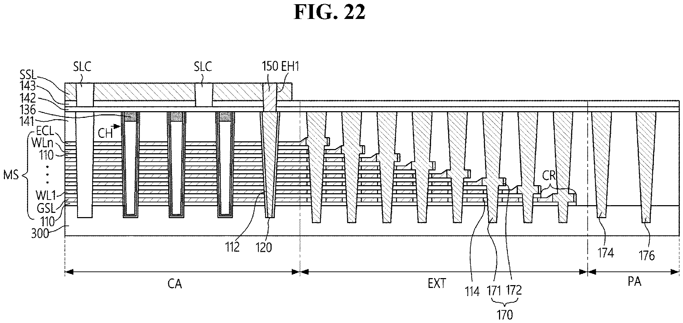

Referring to FIG. 22, the string isolation structure SLC isolating the string select line SSL may be formed on the cell array region CA. For example, the bottom surface of the string isolation structure SLC may be disposed higher than the top surface of the first interlayer insulating layer 141.

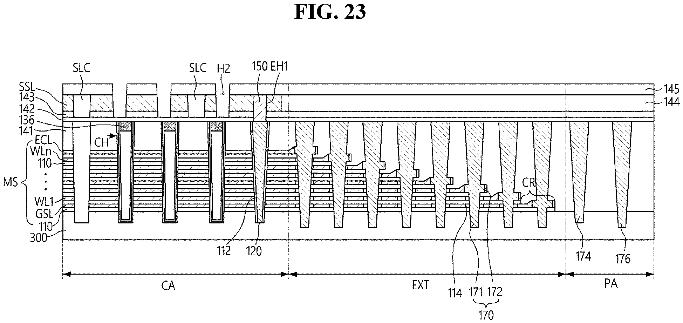

Referring to FIG. 23, the fourth interlayer insulating layer 144 may be formed on the third interlayer insulating layer 143. The top surface of the third interlayer insulating layer 143 and the top surface of the string select line SSL may be disposed substantially on the same plane.

Referring to FIG. 23, the fifth interlayer insulating layer 145 may be formed on the string select line SSL and the fourth interlayer insulating layer 144.

A second hole H2 penetrating the fifth interlayer insulating layer 145, the string select line SSL, and the third interlayer insulating layer 143 may be formed. The second hole H2 may overlap a part of the channel structure CH in a direction perpendicular to the front side of the substrate 300. The second hole H2 may expose the second interlayer insulating layer 142. The second hole H2 may be shifted in a direction away from the string isolation structure SLC that does not overlap the word line cutting structure WLC. For example, with respect to the center of the channel structure CH, the center of the second hole H2 may be shifted in a direction away from the string isolation structure SLC that does not overlap the word line cutting structure WLC in the third direction Z.

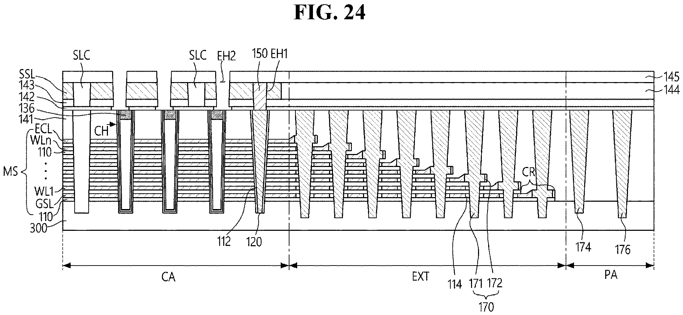

Referring to FIG. 24, the second interlayer insulating layer 142 may be removed through the second hole H2 to form a second extension hole EH2. A part of the second interlayer insulating layer 142 exposed by the second hole H2 may be removed to form the second extension hole EH2. The second extension hole EH2 may expose a part of the top surface of the channel structure CH. The second extension hole EH2 may expose a part of the top surface of the first channel pattern 130 and a part of the top surface of the first channel pad 136.

The anti-arcing contact 120 may prevent an arcing phenomenon by grounding the string select line SSL during the manufacturing process of the semiconductor memory device. For example, an arcing phenomenon may occur in the case of forming a through hole for forming the string isolation structure SLC and/or forming a through hole for forming the string select channel structure SCH (for example, the second hole H2 in FIG. 23 and the second extension hole EH2 in FIG. 24). At this time, charges accumulated in the string select line SSL may be discharged to the substrate 300 through the anti-arcing sacrificial layer 150 and the anti-arcing contact 120. That is, the anti-arcing sacrificial layer 150 and the anti-arcing contact 120 may provide a passage through which the charges are discharged to the substrate 300. Accordingly, electrical characteristics and reliability of the semiconductor memory device may be improved.

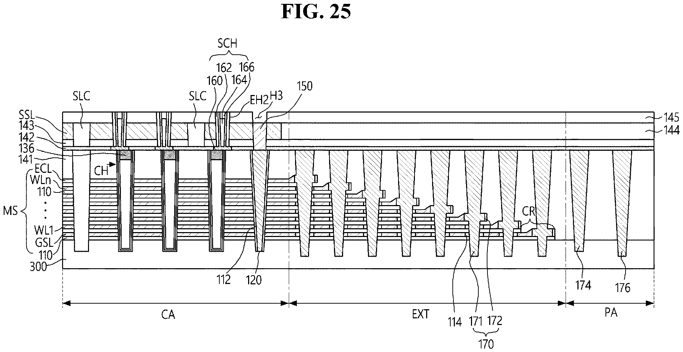

Referring to FIG. 25, the string select channel structure SCH may be formed in the second hole H2. The string select channel structure SCH including the second channel pattern 160, the second channel insulating pattern 162, the second filling pattern 164, and the second channel pad 166 may be formed. The second channel pattern 160 may be in contact with the first channel pad 136 and the first channel pattern 130.

A third hole H3 penetrating the fifth interlayer insulating layer 145 may be formed. The third hole H3 may expose the top surface of the anti-arcing sacrificial layer 150.

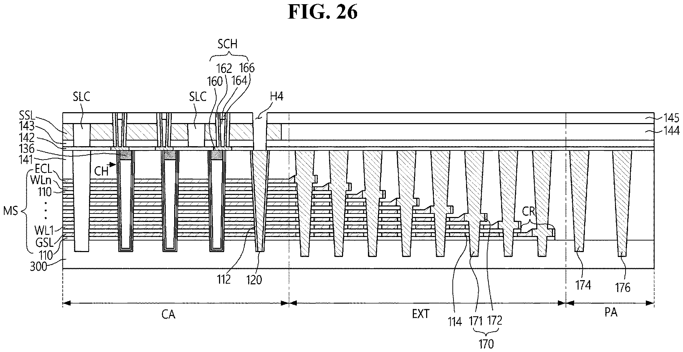

Referring to FIG. 26, the anti-arcing sacrificial layer 150 may be removed through the third hole H3. Accordingly, a fourth hole H4 exposing the top surface of the anti-arcing contact 120 may be formed.

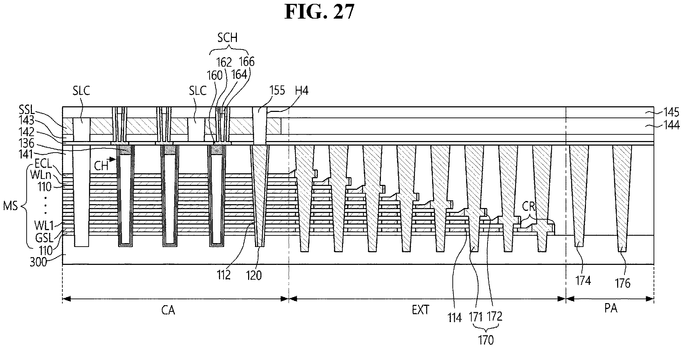

Referring to FIG. 27, the anti-arcing insulating pattern 155 filling the fourth hole H4 may be formed.

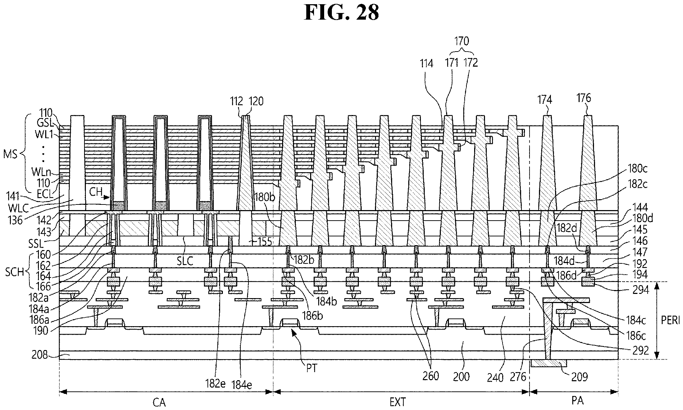

Referring to FIG. 28, the studs 180b, 180c, and 180d may be formed in the second to fifth interlayer insulating layers 142 to 145. The sixth and seventh interlayer insulating layers 146 and 147 may be sequentially formed on the fifth interlayer insulating layer 145. The studs 182a, 182b, 182c, and 182d may be formed in the sixth interlayer insulating layer 146. The stud 182e may be formed in the fifth interlayer insulating layer 145 and the sixth interlayer insulating layer 146. The studs 184a, 184b, 184c, 184d and 184e may be formed in the seventh interlayer insulating layer 147. The first inter-wiring insulating layer 190 may be formed on the seventh interlayer insulating layer 147. The first metal patterns 186a, 186b, 186c, and 186d, the first bonding via 192, and the first bonding metal 194 may be formed in the first inter-wiring insulating layer 190.

The peripheral circuit structure PERI may be provided. The peripheral circuit structure PERI may include the peripheral circuit board 200, the peripheral circuit element PT, the wiring structure 260, the second inter-wiring insulating layer 240, the second bonding via 292, and the second bonding metal 294. The second input/output pad 209 electrically connected via the second input/output contact 276 to the wiring structure 260 may be formed on the second insulating layer 208 on the back side of the peripheral circuit board 200.

The peripheral circuit structure PERI may be bonded to the front side of the substrate 300. The first bonding metal 194 and the second bonding metal 294 may be bonded to each other.

The substrate 300 may be removed. Accordingly, the lower portion of the channel structure CH may be exposed.

Next, referring to FIG. 4, a part of the first channel insulating pattern 132 of the exposed channel structure CH may be removed. Accordingly, the first channel pattern 130 may be exposed. The top surface of the first channel pattern 130 and a part of the sidewall of the first channel pattern 130 may be exposed.

The source layer 102 covering the word line cutting structure WLC, the channel structure CH, and the source contact 174 may be formed. The source layer 102 may be in contact with the first channel pattern 130 of the channel structure CH. Accordingly, the channel structure CH may be electrically connected to the source layer 102. The insulating layer 101 covering the cell contact 170 exposed by the source layer 102, the anti-arcing contact 120, and the input/output contact 176 may be formed. The cell substrates 101 and 102 including the insulating layer 101 and the source layer 102 may be formed. The first insulating layer 108 and the first input/output pad 109 may be formed on the cell substrates 101 and 102. The first input/output pad 109 may be electrically connected to the input/output contact 176 through the contact 178.

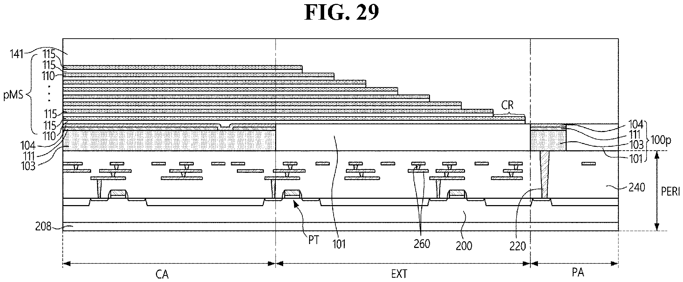

FIGS. 29 to 31 are views illustrating intermediate operations for explaining a method for fabricating a semiconductor memory device according to some example embodiments. For simplicity of description, redundant parts of the description made with reference to FIGS. 1 to 28 may be recapitulated or omitted.

Referring to FIG. 29, the peripheral circuit structure PERI may be provided. A pre-cell substrate 100p and the pre-mold structure pMS may be formed on the peripheral circuit structure PERI. The pre-cell substrate 100p may include the insulating layer 101, the semiconductor layer 103, the source sacrificial layer 111, and the support layer 104. The source sacrificial layer 111 and the support layer 104 may be formed on the semiconductor layer 103. The source sacrificial layer 111 may include a material having an etch selectivity with respect to the mold insulating layer 110. The support layer 104 may include a material having an etch selectivity with respect to the source sacrificial layer 111. For example, the source sacrificial layer 111 may include silicon nitride, and the support layer 104 may include polysilicon.

The pre-mold structure pMS may be formed on the pre-cell substrate 100p. The first interlayer insulating layer 141 covering the pre-cell substrate 100p and the pre-mold structure pMS may be formed.

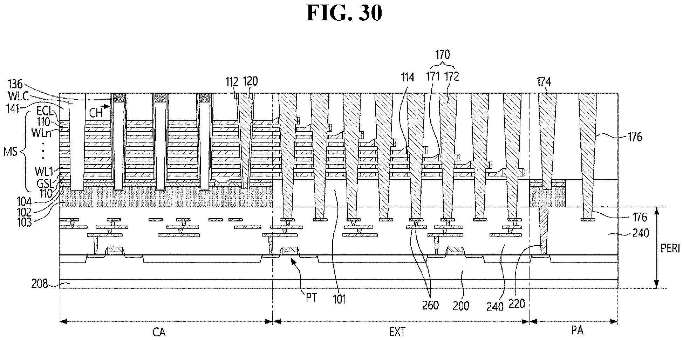

Referring to FIGS. 29 and 30, the channel structure CH penetrating the pre-mold structure pMS may be formed on the cell array region CA. The anti-arcing contact 120 penetrating the pre-mold structure pMS may be formed on the cell array region CA. The first insulating pattern 112 may be formed on the sidewall of the anti-arcing contact 120. The anti-arcing contact 120 may be connected to the peripheral circuit board 200 through the semiconductor layer 103 and the through via 220. The cell contact 170 penetrating the pre-mold structure pMS may be formed on the extension region EXT. The second insulating pattern 114 may be formed between the mold sacrificial layer 115 and the cell contact 170 in a region other than the connection region. The source contact 174 penetrating the first interlayer insulating layer 141 may be formed on the semiconductor layer 103 of the pad region PA. The cell contact 170 and the input/output contact 176 may be electrically connected to the wiring structure 260 while penetrating the insulating layer 101.

The word line cutting hole WLCH penetrating the pre-mold structure pMS may be formed on the cell array region CA. The mold sacrificial layer 115 exposed by the word line cutting structure WLC may be selectively removed, and the gate electrodes GSL, WL1 to WLn, and ECL replacing the area where the mold sacrificial layer 115 is removed may be formed.

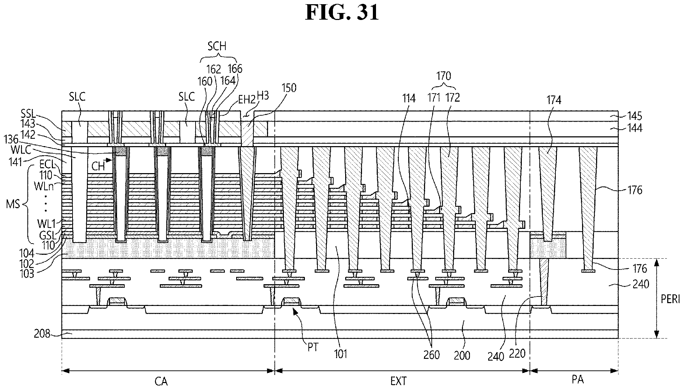

Referring to FIG. 31, the anti-arcing sacrificial layer 150, the string select line SSL, the first to fifth interlayer insulating layers 141 to 145, the string isolation structure SLC, and the string select channel structure SCH may be formed. The anti-arcing contact 120 may be electrically connected to the string select line SSL through the anti-arcing sacrificial layer 150. The string select line SSL may be connected to the peripheral circuit board 200 through the anti-arcing sacrificial layer 150, the anti-arcing contact 120, the semiconductor layer 103, and the through via 220.

The anti-arcing contact 120 may prevent an arcing phenomenon by grounding the string select line SSL during the manufacturing process of the semiconductor memory device. For example, an arcing phenomenon may occur in the case of forming a through hole for forming the string isolation structure SLC and/or forming a through hole for forming the string select channel structure SCH (for example, the second hole H2 in FIG. 23 and the second extension hole EH2 in FIG. 24). At this time, charges accumulated in the string select line SSL may be discharged to the peripheral circuit board 200 through the anti-arcing sacrificial layer 150 and the anti-arcing contact 120. That is, the anti-arcing sacrificial layer 150 and the anti-arcing contact 120 may provide a passage through which the charges are discharged to the peripheral circuit board 200. Accordingly, electrical characteristics and reliability of the semiconductor memory device may be improved.

Referring to FIG. 11, the studs 180b, 180c, and 180d may be formed in the second to fifth interlayer insulating layers 142 to 145. The sixth and seventh interlayer insulating layers 146 and 147 may be sequentially formed on the fifth interlayer insulating layer 145. The studs 182a, 182b, 182c, and 182d may be formed in the sixth interlayer insulating layer 146. The stud 182e may be formed in the fifth interlayer insulating layer 145 and the sixth interlayer insulating layer 146. The studs 184a, 184b, 184c, 184d and 184e may be formed in the seventh interlayer insulating layer 147. The first inter-wiring insulating layer 190 may be formed on the seventh interlayer insulating layer 147. The first metal patterns 186a, 186b, 186c, and 186d may be formed in the first inter-wiring insulating layer 190.

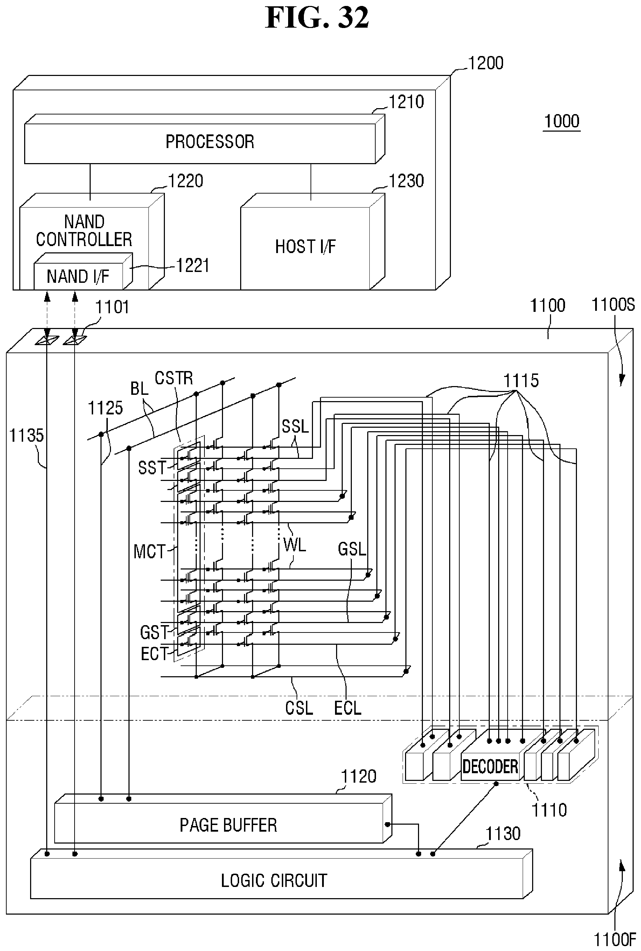

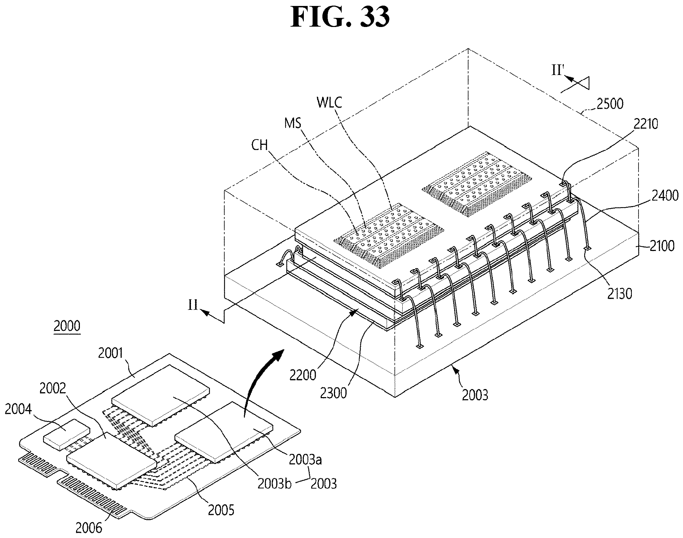

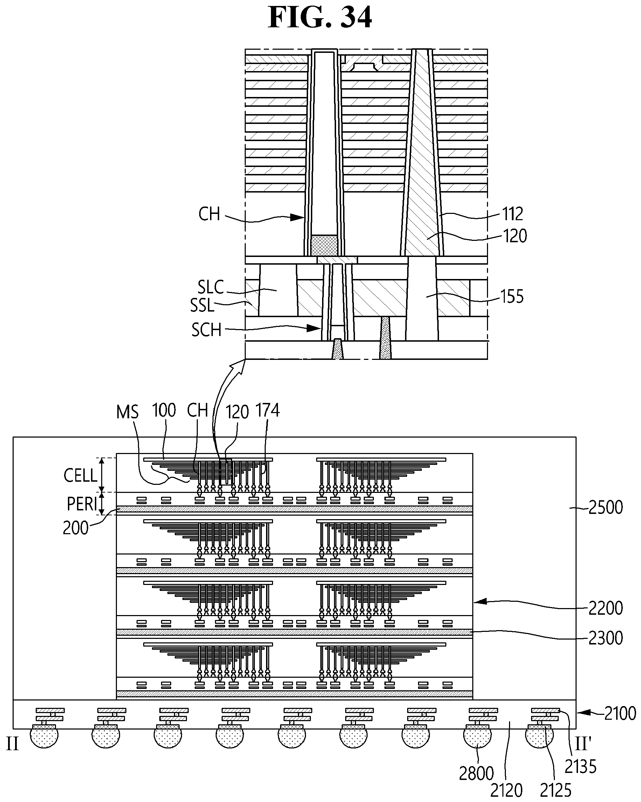

FIG. 32 is an example block diagram illustrating an electronic system according to some example embodiments. FIG. 33 is an example perspective view illustrating an electronic system according to some example embodiments. FIG. 34 is a schematic cross-sectional view taken along line II-II' of FIG. 33.

Referring to FIG. 32, an electronic system 1000 according to some example embodiments may include a nonvolatile memory device 1100 and a controller 1200 electrically connected to the nonvolatile memory device 1100. The electronic system 1000 may be a storage device including one or a plurality of nonvolatile memory devices 1100, or an electronic device including a storage device. For example, the electronic system 1000 may be a solid state drive (SSD) device including one or a plurality of nonvolatile memory devices 1100, a universal serial bus (USB), a computing system, a medical device, or a communication device.

The nonvolatile memory device 1100 may be, for example, a NAND flash memory device, e.g., the nonvolatile memory device described with reference to FIGS. 1 to 16. The nonvolatile memory device 1100 may include a first structure 1100F and a second structure 1100S on the first structure 1100F.

The first structure 1100F may be a peripheral circuit structure including a decoder circuit 1110 (e.g., the row decoder 33 in FIG. 1), a page buffer 1120 (e.g., the page buffer 35 in FIG. 1), and a logic circuit 1130 (e.g., the control logic 37 in FIG. 1).

The second structure 1100S may include the common source line CSL, the plurality of bit lines BL, and the plurality of cell strings CSTR described above with reference to FIG. 2. The cell strings CSTR may be connected to the decoder circuit 1110 via the word lines WL, at least one string select line SSL, and at least one ground select line GSL. Further, the cell strings CSTR may be connected to the page buffer 1120 via the bit lines BL.

In some example embodiments, the common source line CSL and the cell strings CSTR may be electrically connected to the decoder circuit 1110 via first connection lines 1115 that extend from the first structure 1100F to the second structure 1100S.

In some example embodiments, the bit lines BL may be electrically connected to the page buffer 1120 via second connection lines 1125 that extend from the first structure 1100F to the second structure 1100S.

The nonvolatile memory device 1100 may communicate with the controller 1200 through an input/output pad 1101 electrically connected to the logic circuit 1130 (e.g., the control logic 37 in FIG. 1). The input/output pad 1101 may be electrically connected to the logic circuit 1130 through an input/output connection wiring 1135 extending from the first structure 1100F to the second structure 1100S.

The controller 1200 may include a processor 1210, a NAND controller 1220, and a host interface 1230. In some example embodiments, the electronic system 1000 may include a plurality of nonvolatile memory devices 1100. In this case, the controller 1200 may control the plurality of nonvolatile memory devices 1100.

The processor 1210 may control the overall operation of the electronic system 1000 including the controller 1200. The processor 1210 may operate according to a predetermined firmware, and may access the nonvolatile memory device 1100 by controlling the NAND controller 1220. The NAND controller 1220 may include a NAND interface 1221 that communicates with the nonvolatile memory device 1100. A control command for controlling the nonvolatile memory device 1100, data to be written to the memory cell transistors MCT of the nonvolatile memory device 1100, data to be read from the memory cell transistors MCT of the nonvolatile memory device 1100, and the like may be transmitted through the NAND interface 1221. The host interface 1230 may provide a communication function between the electronic system 1000 and an external host. When the control command is received from the external host through the host interface 1230, the processor 1210 may control the nonvolatile memory device 1100 in response to the control command.

Referring to FIGS. 32 to 34, an electronic system 2000 according to some example embodiments may include a main substrate 2001, a main controller 2002 mounted on the main substrate 2001, one or more semiconductor packages 2003, and a DRAM 2004. The semiconductor package 2003 and the DRAM 2004 may be connected to the main controller 2002 by wiring patterns 2005 formed on the main substrate 2001.

The main substrate 2001 may include a connector 2006 having a plurality of pins for connection to the external host. In the connector 2006, the number and arrangement of the pins may vary depending on a communication interface between the electronic system 2000 and the external host. In some example embodiments, the electronic system 2000 may communicate with the external host through any one of interfaces such as universal serial bus (USB), peripheral component interconnect express (PCIe), serial advanced technology attachment (SATA), and M-PHY for universal flash storage (UFS). In some example embodiments, the electronic system 2000 may be operated by a power supplied from the external host through the connector 2006. The electronic system 2000 may further include a power management integrated circuit (PMIC) that distributes the power supplied from the external host to the main controller 2002 and the semiconductor package 2003.

The main controller 2002 may write or read data to/from the semiconductor package 2003, and may improve the operation speed of the electronic system 2000.

The DRAM 2004 may be a buffer memory for reducing a speed difference between the external host and the semiconductor package 2003 as a data storage space. The DRAM 2004 included in the electronic system 2000 may also operate as a sort of cache memory, and may also provide a space for temporarily storing data in controlling the semiconductor package 2003. When the electronic system 2000 includes the DRAM 2004, the main controller 2002 may include not only a NAND controller for controlling the semiconductor package 2003 but also a DRAM controller for controlling the DRAM 2004.

The semiconductor package 2003 may include a first semiconductor package 2003a and a second semiconductor package 2003b spaced apart from each other. Each of the first semiconductor package 2003a and the second semiconductor package 2003b may be a semiconductor package including a plurality of semiconductor chips 2200. Each of the first semiconductor package 2003a and the second semiconductor package 2003b may include a package substrate 2100, the semiconductor chips 2200 on the package substrate 2100, adhesive layers 2300 respectively disposed on the bottom surfaces of the semiconductor chips 2200, connection structures 2400 electrically connecting the semiconductor chips 2200 to the package substrate 2100, and a molding layer 2500 covering the semiconductor chips 2200 and the connection structures 2400 above the package substrate 2100.

The package substrate 2100 may be a printed circuit board including upper package pads 2130. Each of the semiconductor chips 2200 may include an input/output pad 2210. The input/output pad 2210 may correspond to the input/output pad 1101 of FIG. 32.

In some example embodiments, the connection structure 2400 may be a bonding wire that electrically connects the input/output pad 2210 to the upper package pads 2130. Accordingly, in each of first semiconductor package 2003a and the second semiconductor package 2003b, the semiconductor chips 2200 may be electrically connected to each other, and may be electrically connected to the upper package pads 2130 of the package substrate 2100, by a wire bonding method. In some example embodiments, in each of the first semiconductor package 2003a and the second semiconductor package 2003b, the semiconductor chips 2200 may be electrically connected to each other by a connection structure including a through silicon via (TSV) instead of the wire bonding type connection structure 2400.

In some example embodiments, the main controller 2002 and the semiconductor chips 2200 may be included in one package. In some example embodiments, the main controller 2002 and the semiconductor chips 2200 may be mounted on a separate interposer substrate different from the main substrate 2001, and the main controller 2002 may be connected to the semiconductor chips 2200 by wirings formed on the interposer substrate.

In some example embodiments, the package substrate 2100 may be a printed circuit board. The package substrate 2100 may include a package substrate body portion 2120, the upper package pads 2130 disposed on the top surface of the package substrate body portion 2120, lower pads 2125 arranged on the bottom surface of the package substrate body portion 2120 or exposed through the bottom surface thereof, and internal wirings 2135 electrically connecting the upper pads 2130 to the lower pads 2125 in the package substrate body portion 2120. The upper pads 2130 may be electrically connected to the connection structures 2400. The lower pads 2125 may be connected to the wiring patterns 2005 of the main substrate 2001 of the electronic system 2000 through conductive connectors 2800, as shown in FIG. 34.

Referring to FIGS. 33 and 34, in the electronic system according to some example embodiments, each of the semiconductor chips 2200 may include the nonvolatile memory device described above with reference to FIGS. 1 to 16. For example, each of the semiconductor chips 2200 may include the peripheral circuit structure PERI and the memory cell structure CELL. For example, the peripheral circuit structure PERI may include the peripheral circuit board 200 described above with reference to FIGS. 1 to 16. In addition, by way of example, the memory cell structure CELL may include a substrate 100 comprising cell substrates 101 and 102, the mold structure MS, the channel structure CH, the string select channel structure SCH, the anti-arcing contact 120, the first insulating pattern 112, the anti-arcing insulating pattern 155, the string isolation structure SLC, the string select line SSL and the source contact 174 described above with reference to FIGS. 1 to 16.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, an application-specific integrated circuit (ASIC), etc.

In concluding the detailed description, those skilled in the art will appreciate that many variations and modifications can be made to example embodiments of inventive concepts without substantially departing from the principles of the present disclosure. Therefore, the presented are used in a generic and descriptive sense only and not for purposes of limitation.

Embodiments are set out in the following clauses:
1. A semiconductor memory device comprising:
   a cell substrate;
   a mold structure including a plurality of gate electrodes stacked on the cell substrate;
   a channel structure penetrating the mold structure;
   a string select line on the mold structure;
   a string select channel structure penetrating the string select line and contacting the channel structure;
   an anti-arcing contact penetrating the mold structure;
   an insulating pattern between the anti-arcing contact and the plurality of gate electrodes; and
   an anti-arcing insulating pattern penetrating the string select line and contacting the anti-arcing contact.
2. The semiconductor memory device of clause 1, wherein the anti-arcing contact is at an end of the string select line.
3. The semiconductor memory device of claim 2, further comprising:
   a stud; and
   a bit line on the stud, wherein
   the stud is on the string select channel structure without being on the anti-arcing insulating pattern.
4. The semiconductor memory device of any preceding clause, wherein the insulating pattern extends along a sidewall of the anti-arcing contact.
5. The semiconductor memory device of any preceding clause, wherein
   the cell substrate comprises a source layer, and
   a sidewall of a channel pattern of the channel structure is in contact with the source layer.
6. The semiconductor memory device of any preceding clause, wherein
   the cell substrate comprises a source layer, and
   a bottom surface of a channel pattern of the channel structure is in contact with the source layer.
7. The semiconductor memory device of any preceding clause, further comprising:
   a peripheral circuit board;
   a peripheral circuit element on the peripheral circuit board; and
   a peripheral circuit structure on the peripheral circuit board, wherein
   the peripheral circuit structure includes a wiring structure electrically connected to the peripheral circuit element, and
   the cell substrate is between the mold structure and the peripheral circuit structure.
8. The semiconductor memory device of any of clauses 1 to 6, further comprising:
   a peripheral circuit board;
   a peripheral circuit element on the peripheral circuit board; and
   a peripheral circuit structure on the peripheral circuit board, wherein
   the peripheral circuit structure includes a wiring structure electrically connected to the peripheral circuit element, , and
   the mold structure is between the cell substrate and the peripheral circuit structure.
9. The semiconductor memory device of any preceding clause, wherein
   the anti-arcing contact comprises a first portion and a second portion on the first portion, and
   a width of a top surface of the first portion is greater than a width of a top surface of the second portion.
10. The semiconductor memory device of any preceding clause, wherein the string select channel structure overlaps a part of the channel structure.
11. The semiconductor memory device of any preceding clause, wherein
   the string select channel structure comprises a filling pattern, a channel pattern on the filling pattern, and a channel insulating pattern between the filling pattern and the string select line, and
   the channel pattern is and in contact with the channel structure.
12. A semiconductor memory device comprising:
   a cell substrate including a cell array region and an extension region;
   a mold structure including a plurality of gate electrodes stacked on the cell array region, the plurality of gate electrodes being stacked in a stepwise manner on the extension region and each including a connection region having a top surface exposed;
   a channel structure penetrating the mold structure, the channel structure on the cell array region;
   a string select line on the mold structure;
   a string select channel structure penetrating the string select line and contacting the channel structure;
   an anti-arcing contact on the cell array region, the anti-arcing contact penetrating the mold structure, and a structure of the anti-arcing contact being different from a structure of the channel structure; and
   an insulating pattern between the anti-arcing contact and the plurality of gate electrodes.
13. The semiconductor memory device of clause 12, wherein the anti-arcing contact overlaps the string select line in a direction from the cell substrate toward the mold structure.
14. The semiconductor memory device of clause 12 or clause 13, further comprising:
   an anti-arcing insulating pattern on the cell array region, wherein
   the anti-arcing insulating pattern penetrates the string select line and contacts the anti-arcing contact.
15. The semiconductor memory device of any of clauses 12-14, further comprising:
   a cell contact electrically connected to the connection region of a corresponding one of the plurality of gate electrodes on the extension region, wherein
   the cell contact penetrates the mold structure.

## Claims

1. A semiconductor memory device comprising:
a cell substrate;
a mold structure including a plurality of gate electrodes stacked on the cell substrate;
a channel structure penetrating the mold structure;
a string select line on the mold structure;
a string select channel structure penetrating the string select line and contacting the channel structure;
an anti-arcing contact penetrating the mold structure;
an insulating pattern between the anti-arcing contact and the plurality of gate electrodes; and
an anti-arcing insulating pattern penetrating the string select line and contacting the anti-arcing contact.

2. The semiconductor memory device of claim 1, wherein the anti-arcing contact is at an end of the string select line.

3. The semiconductor memory device of claim 1 or 2, further comprising:
a stud; and
a bit line on the stud, wherein
the stud is on the string select channel structure without being on the anti-arcing insulating pattern.

4. The semiconductor memory device of any preceding claim, wherein the insulating pattern extends along a sidewall of the anti-arcing contact.

5. The semiconductor memory device of any preceding claim, wherein
the cell substrate comprises a source layer, and
a sidewall of a channel pattern of the channel structure is in contact with the source layer.

6. The semiconductor memory device of any preceding claim, wherein
the cell substrate comprises a source layer, and
a bottom surface of a channel pattern of the channel structure is in contact with the source layer.

7. The semiconductor memory device of any preceding claim, further comprising:
a peripheral circuit board;
a peripheral circuit element on the peripheral circuit board; and
a peripheral circuit structure on the peripheral circuit board, wherein
the peripheral circuit structure includes a wiring structure electrically connected to the peripheral circuit element, and
the cell substrate is between the mold structure and the peripheral circuit structure.

8. The semiconductor memory device of any of claims 1 to 6, further comprising:
a peripheral circuit board;
a peripheral circuit element on the peripheral circuit board; and
a peripheral circuit structure on the peripheral circuit board, wherein
the peripheral circuit structure includes a wiring structure electrically connected to the peripheral circuit element, and
the mold structure is between the cell substrate and the peripheral circuit structure.

9. The semiconductor memory device of any preceding claim, wherein
the anti-arcing contact comprises a first portion and a second portion on the first portion, and
a width of a bottom surface of the first portion is greater than a width of a top surface of the second portion.

10. The semiconductor memory device of any preceding claim, wherein the string select channel structure overlaps a part of the channel structure.

11. The semiconductor memory device of any preceding claim, wherein
the string select channel structure comprises a filling pattern, a channel pattern on the filling pattern, and a channel insulating pattern between the channel pattern and the string select line, and
the channel pattern is and in contact with the channel structure.

12. A method for fabricating a semiconductor memory device comprises:
forming a mold structure on a substrate, the mold structure including a plurality of gate electrodes stacked on the substrate;
forming a channel structure penetrating the mold structure and an anti-arcing contact penetrating the mold structure, the anti-arcing contact being in contact with the substrate;
forming a string select line on the mold structure;
forming an anti-arcing sacrificial layer penetrating the string select line, the anti-arcing sacrificial layer contacting the anti-arcing contact and containing a conductive material;
after the forming of the anti-arcing sacrificial layer, forming a string select channel structure on the channel structure, the string select channel structure penetrating the string select line;
forming a hole through the string select line by removing the anti-arcing sacrificial layer, the hole exposing at least a part of the anti-arcing contact; and
forming an anti-arcing insulating pattern in the hole, the anti-arcing insulating pattern filling the hole.
